(19) Europäisches Patentamt
European Patent Office
Office européen des brevets

(11) EP 2 720 465 A1

(12) **EUROPEAN PATENT APPLICATION**

(43) Date of publication:
**16.04.2014 Bulletin 2014/16**

(21) Application number: **13184107.4**

(22) Date of filing: **12.09.2013**

(51) Int Cl.:
***H04N 19/426*** *(2014.01)*
***H04N 19/146*** *(2014.01)*
***H04N 19/14*** *(2014.01)*
***H04N 19/85*** *(2014.01)*
***H04N 19/124*** *(2014.01)*
***G09G 3/36*** *(2006.01)*
***H04N 19/186*** *(2014.01)*
***H04N 19/137*** *(2014.01)*
***H04N 19/436*** *(2014.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **13.09.2012 KR 20120101506**

(71) Applicant: **Samsung Electronics Co., Ltd**
**Gyeonggi-do 443-742 (KR)**

(72) Inventors:
- **Wang, Miaofeng**
  **443-725 Suwon-si, Gyeonggi-do (KR)**
- **Kim, Yoon Hak**
  **445-160 Hwaseong-si, Gyeonggi-do (KR)**
- **Srivastava, Sumit**
  **443-470 Suwon-si, Gyeonggi-do (KR)**

(74) Representative: **Kuhnen & Wacker**
**Patent- und Rechtsanwaltsbüro**
**Prinz-Ludwig-Straße 40A**
**85354 Freising (DE)**

(54) **Image compression circuit**

(57) An image compression circuit includes an encoder configured to compress a current frame and to output current frame compressed data and a current frame bitstream; a decoder configured to decode the previous frame bitstream and to output previous frame compressed data; a frame memory controller configured to write the current frame bitstream to a frame memory and simultaneously read a previous frame bitstream from the frame memory; a dynamic capacitance compensation controller configured to output a previous frame reference value based on the current frame, the current frame compressed data, and the previous frame compressed data; and an overdrive circuit configured to generate a current overdriven frame including an overdrive pixel value for a current pixel based on a pixel value of the current pixel in the current frame and the previous frame reference value.

FIG. 1

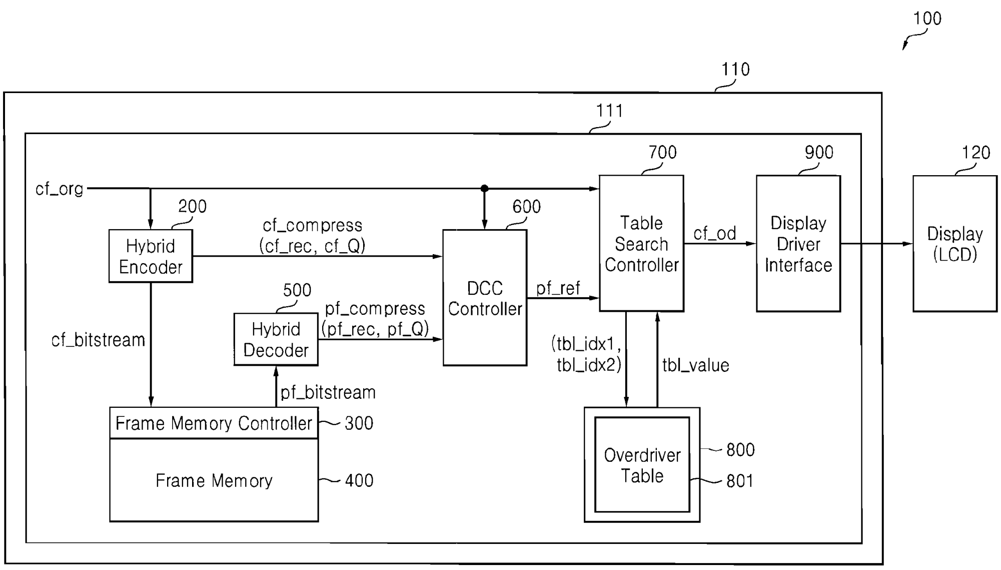




Printed by Jouve, 75001 PARIS (FR)

## Description

CROSS-REFERENCE TO RELATED APPLICATIONS

This application claims priority under 35 U.S.C. § 119(a) from Korean Patent Application No. 10-2012-0101506 filed on September 13, 2012, the disclosure of which is hereby incorporated by reference in its entirety.

BACKGROUND

Embodiments of the inventive concept relate to an image compression circuit, and, more particularly, to an image compression circuit for providing a desired compression ratio for the fast response for liquid crystal displays (LCDs) and accomplishing a high compression ratio without data truncation, a display system including the same, and a method of operating the display system.

LCDs are usually used as display devices that display images. Motion blur may occur in LCDs. Motion blur is the apparent streaking of rapidly moving objects in a still image or a sequence of images, such as a movie or animation. Motion blur occurs when the speed of response of an LCD to the change in a pixel value is slow.

An overdrive algorithm is often used to reduce motion blur in LCDs. The overdrive algorithm is designed to increase the response speed of pixels by applying a voltage higher than a normal voltage to the pixels.

To calculate overdrive voltages with respect to a particular frame, the overdrive algorithm stores previous frame data in memory, compares current frame data with the previous frame data stored in the memory, and calculates the overdrive voltages based on the comparison result. The newly calculated overdrive voltages are output to an LCD and the previous frame data is updated with the current frame data in the memory.

SUMMARY

According to some embodiments of the inventive concept, there is provided an image compression circuit including an encoder configured to compress a current frame and to output current frame compressed data and a current frame bitstream; a frame memory controller configured to write the current frame bitstream to a frame memory and simultaneously read a previous frame bitstream from the frame memory; a decoder configured to decode the previous frame bitstream and to output previous frame compressed data; a dynamic capacitance compensation controller configured to output a previous frame reference value based on the current frame, the current frame compressed data, and the previous frame compressed data; and an overdrive circuit configured to generate a current overdriven frame including an overdrive pixel value for a current pixel based on a pixel value of the current pixel in the current frame and the previous frame reference value.

The encoder may compress the current frame using one of a variable bit rate encoding method and a constant bit rate encoding method and output the current frame compressed data and the current frame bitstream.

The encoder may include a pre-processing circuit configured to pre-process the current frame and to output pre-processed image data; a plurality of variable bit rate encoders configured to encode components included in the pre-processed image data at a variable bit rate; a plurality of constant bit rate encoders configured to encode the component at a constant bit rate; a first switch circuit configured to transmit the components to the variable bit rate encoders or the constant bit rate encoders in response to a first switch signal; a second switch circuit configured to transmit component compressed data and a component bitstream, which are received from the variable bit rate encoders or the constant bit rate encoders, in response to the first switch signal; an accumulator configured to generate all-component accumulated bits by accumulating component bitstreams output for the respective components from the second switch circuit; a first switch controller configured to generate the first switch signal based on the all-component accumulated bits; and an ordered bitstream merging circuit configured to generate the current frame bitstream by merging the component bitstreams for the respective components output from the second switch circuit. The current frame compressed data may include the component compressed data for each of the components.

Each of the variable bit rate encoders may include a quantization circuit configured to generate a quantized value by quantizing a corresponding one of the components based on a final quantization level and to generate the component compressed data for the corresponding component by inverse-quantizing the quantized value; and a coding circuit configured to generate the component bitstream for the corresponding component by encoding the quantized value using one of coders respectively performing different encoding methods.

The components may be YCbCr components, YCoCg components or YUV components. The image coders may include a Golomb coder and a run length coder.

Each of the constant bit rate encoders may include a context-based quantization level determination circuit configured to determine a context-based quantization level for a region including neighboring pixels of the current pixel for a corresponding one of the components using differences between pixel values of the respective neighboring pixels,

a second switch controller configured to generate a second switch signal based on the context-based quantization level, a third switch circuit configured to transmit the corresponding component to one of a first quantizer and an averaging circuit based on the second switch signal, a first inverse-quantizer configured to generate the component compressed data for the corresponding component by inverse-quantizing a first quantized value output from the first quantizer based on the context-based quantization level corresponding to a first quantization level, a second quantizer configured to output a second quantized value by quantizing an output signal of the averaging circuit based on the context-based quantization level corresponding to a second quantization level, a second inverse-quantizer configured to generate the component compressed data for the corresponding component by inverse-quantizing the second quantized value based on the context-based quantization level corresponding to the second quantization level, a fourth switch circuit configured to transmit the component compressed data from one of the first inverse-quantizer and the second inverse-quantizer to the second switch circuit based on the second switch signal, and a fifth switch circuit configured to transmit one of the first quantized value and the second quantized value as the component bitstream for the corresponding component to the second switch circuit based on the second switch signal. The first quantizer may output the first quantized value by quantizing the corresponding component based on the context-based quantization level corresponding to the first quantization level. The averaging circuit may calculate an average of the pixel value of the current pixel and a pixel value of a next pixel of the current pixel.

The ordered bitstream merging circuit may include a plurality of bit buffers configured to store a component bitstream for each of the components; and a merging circuit configured to merge component bitstreams for the respective components, which are output from the respective bit buffers every time when the bit buffers are full, into the current frame bitstream.

When the frame memory includes a plurality frame memory units, the frame memory controller may write the current frame bitstream to one of the frame memory units and simultaneously read the previous frame bitstream from another one of the frame memory units.

The dynamic capacitance compensation controller may include a first stage compensation circuit configured to generate a final smoothness level based on the current frame and to generate a previous frame base reference value based on the current frame, the previous frame compressed data, and the final smoothness level; and a second stage compensation circuit configured to generate the previous frame reference value based on the previous frame base reference value, the current frame, the current frame compressed data, the previous frame compressed data, and the final smoothness level.

The overdrive circuit may include an overdrive table configured to store overdrive pixel values, a table search controller configured to read at least one value corresponding to the pixel value of the current pixel and the previous frame reference value among the overdrive pixel values as at least one search value and to generate the current overdriven frame including the overdrive pixel value for the current pixel based on the at least one search value, and a display driver interface configured to transmit the current overdriven frame to the display.

When the at least one search value includes a plurality of search values, the table search controller may interpolate the search values to generate the current overdriven frame.

According to other embodiments of the inventive concept, there is provided a display system including a liquid crystal display configured to display a current overdriven frame including an overdrive pixel value for a current pixel and an image compression circuit configured to generate the current overdriven frame.

The image compression circuit may include an encoder configured to compress a current frame and to output current frame compressed data and a current frame bitstream; a frame memory controller configured to write the current frame bitstream to a frame memory and simultaneously read a previous frame bitstream from the frame memory; a decoder configured to decode the previous frame bitstream and to output previous frame compressed data; a dynamic capacitance compensation controller configured to output a previous frame reference value based on the current frame, the current frame compressed data, and the previous frame compressed data; and an overdrive circuit configured to generate the current overdriven frame including the overdrive pixel value based on a pixel value of the current pixel in the current frame and the previous frame reference value.

## BRIEF DESCRIPTION OF THE DRAWINGS

FIG. 1 is a block diagram of a display system including a display controller according to some embodiments of the inventive concept;

FIG. 2 is a block diagram of a hybrid encoder included in a hybrid image compression circuit illustrated in FIG. 1;

FIG. 3 is a diagram of a constant bit rate (CBR) unit;

FIG. 4 is a block diagram of one of the variable bit rate (VBR) encoders illustrated in FIG. 2;

FIG. 5 is a conceptual diagram of operations of a context-based quantization level determination circuit illustrated in FIG. 4 according to some embodiments of the inventive concept;

FIG. 6 is a conceptual diagram of operations of a rate-based quantization level determination circuit illustrated in FIG. 4 according to some embodiments of the inventive concept;

FIG. 7 is a conceptual diagram of operations of a quantizer and an inverse-quantizer illustrated in FIG. 4 according to some embodiments of the inventive concept;

FIG. 8 is a conceptual diagram of operations of a third switch controller illustrated in FIG. 4 according to some embodiments of the inventive concept;

FIG. 9 is a conceptual diagram of operations of a Golomb coder illustrated in FIG. 4 according to some embodiments of the inventive concept;

FIG. 10 is a block diagram of one of the constant bit rate (CBR) encoders illustrated in FIG. 2;

FIG. 11 is a block diagram of an ordered bitstream merging circuit illustrated in FIG. 2;

FIG. 12 is a block diagram of operations of a frame memory controller illustrated in FIG. 1 according to some embodiments of the inventive concept;

FIG. 13 is a block diagram of the memory allocation in a frame memory illustrated in FIG. 1;

FIG. 14 is a block diagram of the dynamic capacitance compensation (DCC) controller illustrated in FIG. 1;

FIG. 15 is a block diagram of the motion estimation circuit illustrated in FIG. 14;

FIG. 16 is a diagram of the search range used in the motion estimation circuit illustrated in FIG. 14;

FIGS. 17A through 17C are conceptual diagrams of operations of a smoothness level determination circuit illustrated in FIG. 4 according to some embodiments of the inventive concept;

FIG. 18 is a diagram of an overdrive table illustrated in FIG. 1 according to some embodiments of the inventive concept;

FIG. 19 is a diagram of examples of the display system including the display controller illustrated in FIG. 1 according to some embodiments of the inventive concept; and

FIG. 20 is a flowchart of a method of operating the display system illustrated in FIG. 1 or 19 according to some embodiments of the inventive concept.

## DETAILED DESCRIPTION OF THE EMBODIMENTS

The inventive concept will now be described more fully with reference to the accompanying drawings, in which exemplary embodiments of the inventive concept are shown. The inventive concept may, however, be embodied in many different forms and should not be construed as being limited to the embodiments set forth herein; rather, these embodiments are provided so that this disclosure will be thorough and complete, and will fully convey the inventive concept to those of ordinary skill in the art. Thus, the inventive concept may include all revisions, equivalents, or substitutions which are included in the concept and the technical scope related to the inventive concept. Like reference numerals in the drawings denote like elements. In the drawings, the thicknesses of layers and regions are exaggerated for clarity.

Furthermore, all examples and conditional language recited herein are to be construed as being without limitation to such specifically recited examples and conditions. Throughout the specification, a singular form may include a plural form, unless there is a particular description contrary thereto. Also, terms such as "comprise" or "comprising" are used to specify existence of a recited form, a number, a process, an operation, a component, and/or groups thereof, not excluding the existence of one or more other recited forms, one or more other numbers, one or more other processes, one or more other operations, one or more other components and/or groups thereof.

While terms "first" and "second" are used to describe various components, it is obvious that the components are not limited to the terms "first" and "second". The terms "first" and "second" are used only to distinguish between each component. For example, a first component may indicate a second component or a second component may indicate a first component without conflicting with the inventive concept.

Unless expressly described otherwise, all terms including descriptive or technical terms which are used herein should be construed as having meanings that are obvious to one of ordinary skill in the art. Also, terms that are defined in a general dictionary and that are used in the following description should be construed as having meanings that are equivalent to meanings used in the related description, and unless expressly described otherwise herein, the terms should not be construed as being ideal or excessively formal.

As used herein, the term "and/or" includes any and all combinations of one or more of the associated listed items.

FIG. 1 is a block diagram of a display system 100 including a display controller 110 according to some embodiments of the inventive concept.

The display system 100 includes a display controller 110 and a display 120. The display 120 may be implemented by a liquid crystal display (LCD).

The display system 100 may be, but is not limited to, a television (TV), an Internet protocol TV (IPTV), a three-dimensional (3D) TV, or a portable electronic device, which includes the LCD 120.

The portable electronic device may be, but is not limited to, a laptop computer, a smart phone, a tablet personal computer (PC), a personal digital assistant (PDA), an enterprise digital assistant (EDA), a portable multimedia player (PMP), a personal navigation device or portable navigation device (PND), or an e-book.

The hybrid image compression circuit 111, which can perform an overdrive algorithm to increase the response speed of the LCD 120, may be implemented as a part of the display controller 110.

Referring to FIG. 1, the hybrid image compression circuit 111 includes a hybrid encoder 200, a frame memory controller 300, a frame memory 400, a hybrid decoder 500, a dynamic capacitance compensation (DCC) controller 600, a table search controller 700, a memory 800 having an overdrive table 801 stored thereon, and a display driver interface 900. An overdrive circuit is comprised of the table search controller 700, the memory 800, and the display driver interface 900.

The hybrid encoder 200 functions as a compressor. The hybrid encoder 200 receives and compresses a current (original) frame cf_org and outputs current (original) frame compressed data cf_compress to the DCC controller 600 and simultaneously outputs a current (original) frame bitstream cf_bitstream to the frame memory controller 300.

The current frame cf_org may be expressed in a first data format, for example, of RGB components. The current frame compressed data cf_compress may be expressed in a second data format, for example, of YCbCr components, YUV components, YCoCg components, and on the like.

The current frame compressed data cf_compress may include reconstructed values cf_rec and additional information, e.g., a quantization level cf_Q, in a coding operation.

The frame memory controller 300 writes the current frame bitstream cf_bitstream to the frame memory 400 and simultaneously transmits a previous frame bitstream pf_bitstream from the frame memory 400 to the hybrid decoder 500.

According to the control of the frame memory controller 300, the frame memory 400 simultaneously performs a write operation of writing the current frame bitstream cf_bitstream to a first frame memory unit and a read operation of outputting the previous frame bitstream pf_bitstream read from a second frame memory unit different from the first frame memory unit to the hybrid decoder 500.

While the write operation and the read operation are being performed at the same time, the frame memory controller 300 may control the operation of the frame memory 400 so that the write operation and the read operation are not performed simultaneously on one frame memory unit or overwriting does not occur in one frame memory unit.

When the frame memory 400 stores the current frame bitstream cf_bitstream, the hybrid decoder 500, which may function as a de-compressor, decompresses the previous frame bitstream pf_bitstream and retrieves previous frame compressed data pf_compress. The previous frame compressed data pf_compress may include reconstructed values pf_rec and additional information, e.g., a quantization level pf_Q, in the coding operation.

The previous frame compressed data pf_compress is previous frame retrieved data obtained after compression and may be used to refer to previous frame decompressed data.

The DCC controller 600 generates a previous frame reference value pf_ref for a current pixel included in the current frame cf_org based on the current frame cf_org, the current frame compressed data cf_compress, and the previous frame compressed data pf_compress.

The table search controller 700 searches the overdrive table 801 for at least one search value tbl_value for the current pixel in the current frame cf_org using a pixel value of the current pixel and the previous frame reference value pf_ref as indexes like tbl_idx1=cf_org and tbl_idx2=pr_ref. The table search controller 700 generates an overdrive pixel value for the current pixel in the current frame cf_org using the at least one search value tbl_value and outputs the overdrive pixel value or a current overdriven frame cf_od including the overdrive pixel value to the display driver interface 900.

Accordingly, the current frame cf_org may indicate a current frame in general or a current frame including a current frame current pixel value cf_org_cp_val in specific. The current overdriven frame cf_od may indicate a current overdriven frame in general or a current overdriven frame including an overdrive pixel value in specific.

Here, the pixel value and the previous frame reference value pf_ref may indicate a grayscale voltage, a brightness value, or a luminance value.

The memory 800 may be implemented by a non-volatile memory that can store the overdrive table 801 or a volatile memory used as an operation memory of the table search controller 700. At this time, the operation memory may store or load the overdrive table 801.

The overdrive table 801 may store overdrive pixel values as shown in FIG. 18.

The display driver interface 900 may transmit the overdrive pixel value or the current overdriven frame cf_od including the overdrive pixel value to the display 120.

The display 120, which may be implemented by an LCD, may display an image corresponding to the current overdriven frame cf_od including overdrive pixel values for current pixels.

FIG. 2 is a block diagram of the hybrid encoder 200 included in the hybrid image compression circuit 111 illustrated in FIG. 1. Referring to FIG. 2, the hybrid encoder 200 includes a pre-processing circuit 201, a first switch circuit 203, a first encoder block 210, a second encoder block 230, a first switch controller 240, a second switch circuit 250, an accumulator 255, and an ordered bitstream merging circuit 260.

The pre-processing circuit 201 pre-processes the current frame cf_org and outputs pre-processed image data cf_pre. To achieve higher coding performance, the pre-processing circuit 201 may perform color transformation and sub-sampling on the current frame cf_org. The pre-processed image data cf_pre may include components, which may include image data (e.g., RGB components, YCbCr components, YUV components, or YCoCg components) and additional information, such as pattern information.

The first switch controller 240 receives all-component accumulated bits bits_used from the accumulator 255 and generates a first switch signal SW1 using Equation 1, which will be described later. The all-component accumulated bits bits_used are the result of accumulating all components' bits bits_used_1 through bits_used_m.

In response to the first switch signal SW1 at a first level, e.g., a low level, the first switch circuit 203 transmits the pre-processed image data cf_pre to the first encoder block 210. Accordingly, the first encoder block 210 encodes the components, e.g., the YCbCr components , YUV components or YCoCg components, included in the pre-processed image data cf_pre.

In response to the first switch signal SW1 at the first level, the second switch circuit 250 transmits each of component bitstream cf_bitstream_j (where j=1 through "m" where "m" is a natural number) from the first encoder block 210 to the ordered bitstream merging circuit 260 and transmits each of component compressed data cf_compress_j from the first encoder block 210 to the DCC controller 600. At this time, the current frame compressed data cf_compress includes each component compressed data cf_compress_1 through cf_compress_m.

When the first switch signal SW1 is at the first level, the elements 203, 210, and 250 create a first encoding path.

In response to the first switch signal SW1 at a second level, e.g., a high level, the first switch circuit 203 transmits the pre-processed image data cf_pre to the second encoder block 230. Accordingly, the second encoder block 230 encodes the components, e.g., the YCbCr components, YUV components or YCoCg components, included in the pre-processed image data cf_pre.

In response to the first switch signal SW1 at the second level, the second switch circuit 250 transmits each of component bitstream cf_bitstream_j from the second encoder block 230 to the ordered bitstream merging circuit 260 and transmits each of component compressed data cf_compress_j from the second encoder block 230 to the DCC controller 600.

When the first switch signal SW1 is at the second level, the elements 203, 230, and 250 create a second encoding path.

The accumulator 255 accumulates the number of bits used to encode pixels included in each of component bitstreams cf_bitstream_1 through cf_bitstream_m received from the second switch circuit 250 and outputs the all-component accumulated bits bits_used to the first switch controller 240 according to the accumulate result.

Since the pre-processed image data cf_pre is encoded by the first encoder block 210 or the second encoder block 230 in response to the first switch signal SW1 output from the first switch controller 240, data truncation is prevented.

FIG. 3 is a diagram of a constant bit rate (CBR) unit. The CBR unit is a part of the current frame cf_org and may be defined as a fundamental processing block used to constantly maintain a desired compression ratio. For instance, a single CBR unit may be a single frame, a group of image lines, or a group of pixels.

To maintain the desired compression ratio for a CBR unit, the first switch controller 240 may control the first switch circuit 203 so that the pre-processed image data cf_pre is adaptively transmitted to the first encoder block 210 or the second encoder block 230.

The first switch controller 240 may generate the first switch signal SW1 using an algorithm expressed by Equation 1:

$$\begin{aligned}&\text{if}((n-1)\times bpp_MAX + left_pixels \times bpp_CBR < bits_total - bits_used)\ select\ VBRencoder(s);\\&else\qquad select\ CBRencoder(s);\end{aligned}\tag{1}$$

As shown in FIG. 3, it is necessary to select the first encoder block 210 or the second encoder block 230 before a current pixel "i" in the current frame cf_org is encoded. To do the selection, the first switch controller 240 calculates pixels to be processed in a current CBR unit and the bits left.

The "bits_total - bits_used" indicates the bits left (or the number of bits left). The "(n-1)*bpp_MAX" indicates the maximum bits (or the maximum number of bits) for encoding the pixels currently being processed in a pipeline. The "left_pixels*bpp_CBR" indicates the bits (or the number of bits) required when encoding the pixel left in the CBR unit under the restriction of CBR encoders.

To obtain the desired compression ratio, bits bpp_CBR allocated per pixel in the CBR encoder should not be more than bits bpp_TGT available per pixel at the desired compression ratio. Accordingly, bpp_CBR needs to be less than bpp_TGT.

When bpp_CBR = bpp_TGT and the CBR encoders are selected for one pixel, all pixels left in the CBR unit are encoded by the CBR encoder according to Equation 1.

Referring to Equation 1, (n-1), bpp_MAX, bpp_CBR, and bits_total are fixed values, left_pixels is calculated using an internal counter implemented within the first switch controller 240, and the all-component accumulated bits bits_used are received from the accumulator 255.

Referring back to FIG. 2, the first encoder block 210 includes a plurality of variable bit rate (VBR) encoders 211-1 through 211-m where "m" is a natural number. For instance, the first VBR encoder 211-1 encodes Y-data (i.e., luma data or luminance data) or a Y-component and outputs Y-component compressed data cf_compress_j (where j=1=Y) and a Y-component bitstream cf_bitstream_j (where j=1=Y) to the second switch circuit 250.

The second VBR encoder 211-2 encodes Cb-data (i.e., blue-difference chroma data or a Cb-component), U-data (or a U-component), or Co-data (or Co-component) and outputs Cb, U, or Co-component compressed data cf_compress_j (where j=2=Cb, U, or Co) and a Cb-component bitstream cf_bitstream_j (where j=2=Cb, U, or Co) to the second switch circuit 250.

The third VBR encoder 211-3 encodes Cr-data (i.e., red-difference chroma data or a Cr-component), V-data (or a V-component) or Cg-data (or Cg-component) and outputs Cr, V, or Cg-component compressed data cf_compress_j (where j=3=Cr, V, or Cg) and a Cr-component bitstream cf_bitstream_j (where j=3=Cr, V, or Cg) to the second switch circuit 250.

When the pre-processed image data cf_pre includes pattern information as well, the fourth VBR encoder 211-m (where m=4) encodes the pattern information and outputs pattern-component compressed data cf_compress_j (where j=4) and a pattern-component bitstream cf_bitstream_j (where j=4) to the second switch circuit 250.

The second encoder block 230 includes a plurality of CBR encoder 231-1 through 231-m. While a VBR encoder outputs the number of variable bits per pixel, a CBR encoder outputs the number of fixed bits per pixel.

For instance, the first CBR encoder 231-1 encodes Y-data (or a Y-component) and outputs Y-component compressed data cf_compress_j (where j=1=Y) and a Y-component bitstream cf_bitstream_j (where j=1=Y) to the second switch circuit 250.

The second CBR encoder 231-2 encodes Cb-data (or a Cb-component), U-data (or a U-component), or Co-data (or Co-component) and outputs Cb, U, or Co-component compressed data cf_compress_j (where j=2=Cb, U, or Co) and a Cb, U, or Co-component bitstream cf_bitstream_j (where j=2=Cb, U, or Co) to the second switch circuit 250.

The third CBR encoder 231-3 encodes Cr-data (or a Cr-component), V-data (or a V-component), or Cg-data (or Cg-component) and outputs Cr, V, or Cg-component compressed data cf_compress_j (where j=3=Cr, V, or Cg) and a Cr, V, or Cg-component bitstream cf_bitstream_j (where j=3=Cr, V, or Cg) to the second switch circuit 250.

When the pre-processed image data cf_pre includes pattern information as well, the fourth CBR encoder 231-m (where m=4) encodes the pattern information and outputs pattern-component compressed data cf_compress_j (where j=4) and a pattern-component bitstream cf_bitstream_j (where j=4) to the second switch circuit 250.

The hybrid encoder 200 uses a plurality of the VBR encoders 211-1 through 211-m, which are independent from each other, and a plurality of the CBR encoders 231-1 through 231-m, which are independent from each other, instead of using a single VBR encoder and a single CBR encoder.

Each of the VBR encoders 211-1 through 211-m or each of the CBR encoders 231-1 through 231-m outputs compressed data cf_compress_j and a bitstream cf_bitstream_j for each of components included in the pre-processed image data cf_pre.

The second switch circuit 250 transmits the component compressed data cf_compress_j from the first encoder block 210 or the second encoder block 230 to the DCC controller 600 and transmits the component bitstream cf_bitstream_j from the first encoder block 210 or the second encoder block 230 to the ordered bitstream merging circuit 260. At this time, each component compressed data cf_compress_1 to cf_compress_m is directly used by the DCC controller 600, and therefore, it does not need to be merged with other component compressed data unlike each component bitstream cf_bitstream_1 to cf_bitstream_m.

As described above, the current frame compressed data cf_compress includes the component compressed data cf_compress_1 to cf_compress_m.

The ordered bitstream merging circuit 260 merges all component bitstreams cf_bitstream_1 to cf_bitstream_m received from the second switch circuit 250 into a single bitstream, i.e., the current frame bitstream cf_bitstream.

FIG. 4 is a block diagram of one of the VBR encoders 211-1 through 211-m illustrated in FIG. 2. Referring to FIGS. 2 and 4, the structures and the operations of the VBR encoders 211-1 through 211-m are the same. Thus, for convenience of description, the structure and the operation of the first VBR encoder 211-1 will be described in detail. The first VBR encoder 211-1 encodes a first component cf_pre_1, e.g., a Y-component, of the pre-processed image data cf_pre and outputs first component compressed data cf_compress_1 and a first component bitstream cf_bitstream_1.

The first VBR encoder 211-1 includes a quantization circuit (or a quantization stage) 213 and a coding circuit (or a coding stage) 215.

The quantization circuit 213 quantizes the first component cf_pre_1 of the pre-processed image data cf_pre using a final quantization level Q to generate a quantized value "y", e.g., a quantized value of a current pixel, and inverse-quantizes the quantized value "y" using the final quantization level Q to generate the first component compressed data cf_compress_1.

The coding circuit 215 codes the quantized value "y" using one of a variety of different coding algorithms and generates the first component bitstream cf_bitstream_1 based on the coding result.

The quantization circuit 213 includes a context-based quantization level determination circuit 213-1, a rate-based quantization level determination circuit 213-3, a second switch controller 213-4, a third switch circuit 213-5, a quantizer 213-6, and an inverse-quantizer 213-7.

The context-based quantization level determination circuit 213-1 includes a line buffer 213-2. As shown in FIG. 5, the line buffer 213-2 stores pixel values of a previous line PL and pixel values of a current line CL.

FIG. 5 is a conceptual diagram of operations of the context-based quantization level determination circuit 213-1 illustrated in FIG. 4 according to some embodiments of the inventive concept. Referring to FIGS. 4 and 5, to avoid a feedback loop in hardware implementation, neighboring pixels P1 through P7 of a current pixel CP in the previous line PL are used to calculate a context complexity of the current pixel CP.

In the current embodiments, two context complexities, i.e., a near context complexity near_cc and a far context complexity far_cc are defined.

For convenience of description, it is assumed that three pixels P3, P4, and P5 are included in a first region Pnear_cc for the calculation of the near context complexity near_cc and seven pixels P1 through P7 are included in a second region Pfar_cc for the calculation of the far context complexity far_cc in the embodiments illustrated in FIG. 5.

The near context complexity near_cc is calculated as a minimum value in differences diff3 and diff4 between two pixels P3 and P4 and P4 and P5 among the near neighboring pixels P3, P4, and P5 of the current pixel CP using Equation 2:

$$\begin{cases} \text{near_cc} = \min\limits_{\text{near}}(\{\text{diff}()\}) \\ \text{far_cc} = \sum\limits_{\text{far}}\{\text{diff}(\ )\} \end{cases} \tag{2}$$

The far context complexity far_cc is calculated as the sum of differences diff1 through diff6 between two pixels P1 and P2, P2 and P3, P3 and P4, P4 and P5, P5 and P6, and P6 and P7, respectively, among the far neighboring pixels P1 through P7 of the current pixel CP using Equation 2.

Alternatively, to reduce computational complexity, a far context complexity may be calculated using additional information, such as pattern information, for each of far neighboring pixels instead of calculating the differences between two pixels in pairs among the far neighboring pixels of a current pixel.

The context-based quantization level determination circuit 213-1 calculates the near context complexity near_cc and the far context complexity far_cc using Equation 2 and may calculate a context-based quantization level Qc using the calculation result and Equation 3:

$$Qc = \begin{cases} 0\ (when\quad near_cc\ <= nc0\ \&\&\ far_cc\ <= fc0) \\ 1\ (when\quad near_cc\ <= nc1\ \&\&\ far_cc\ <= fc1) \\ 2\ (when\quad near_cc\ <= nc2\ \&\&\ far_cc\ <= fc2) \\ \qquad\qquad\qquad \dots \\ \text{Q_MAX} \qquad\qquad\qquad \text{otherwise} \end{cases} \tag{3}$$

where variables nc0, nc1, nc2, ..., fc0, fc1, fc2, ..., and Q_MAX are predetermined values, nc0<nc1, nc1 <nc2, fc0<fc1, fc1<fc2, and Q_MAX is a maximum value.

The context-based quantization level Qc is dependent only on the context complexity. Accordingly, context-based quantization levels have consistency in different regions. The context-based quantization level Qc increases in regions having a high context complexity and decreases in regions having a low context complexity.

When it is difficult to encode values of the pixels P1 through P7, the near context complexity near_cc and the far context complexity far_cc are high, and therefore, the context-based quantization level Qc is also high. However, when the encoding of the pixels P3 through P5 is difficult but the encoding of the remaining pixels P1, P2, P6 and P7 is easy, the near context complexity near_cc is high but the far context complexity far_cc is low, and therefore, the context-based quantization level Qc is low.

The rate-based quantization level determination circuit 213-3 calculates a rate-based quantization level Qr based on the all-component accumulated bits bits_used, which are used for the encoded pixels in the current CBR unit, and a budget budget_for_pixels_encoded, which are allocated for the encoded pixels in the current CBR unit at the desired compression ratio.

FIG. 6 is a conceptual diagram of operations of the rate-based quantization level determination circuit 213-3 illustrated in FIG. 4 according to some embodiments of the inventive concept. As shown in FIG. 3, "pixels encoded" indicates the number of the encoded pixels. When the "pixels encoded" is N1, the all-component accumulated bits bits_used indicates the number of bits used to encode N1 pixels and is the same as the sum of each component bitstreams cf_bitstream_1 to bitstreams cf_bitstream_m up to the present.

For instance, "bits_used_j" indicates the sum of j-component's bitstreams. "budget_for_pixels_encoded" indicates a budget for the N1 pixels in accordance with the desired compression ratio. For instance, when a desired compression ratio 1/CR is 1/10 and a value of a single pixel is 8 bits, the budget for the pixel is 8 bits*1/10 = 0.8 bits. Accordingly, the budget_for_pixels_encoded for N1 pixels is N1*0.8 bits.

In FIG. 6, (N1*8) indicates the number of bits in original data for a single component, e.g., an R-component, a G-component, or a B-component.

The rate-based quantization level determination circuit 213-3 receives accumulated bits bits_used_1 from an accumulator 215-6 and may calculate the rate-based quantization level Qr using Equation 4:

$$Qr = \begin{cases} 0\ (when\ \ budget_for_pixels_encoded - bits_used >= r0) \\ 1\ (when\ \ budget_for_pixels_encoded - bits_used >= r1) \\ 2\ (when\ \ budget_for_pixels_encoded - bits_used >= r2) \\ \qquad\qquad\qquad\qquad \dots \\ \text{Q_MAX} \qquad\qquad\qquad\qquad \text{otherwise} \end{cases} \quad (4)$$

where variables r0, r1, r2, ..., and Q_MAX are predetermined values, r0>r1, r1>r2, and Q_MAX is a maximum value. At this time, the rate-based quantization level determination circuit 213-3 calculates the "budget_for_pixels_encoded" using an internal counter that counts the number of pixels encoded.

When a remaining budget, i.e., "budget_for_pixels_encoded - bits_used" increases, the rate-based quantization level Qr decreases. When the remaining budget, i.e., "budget_for_pixels_encoded - bits_used" decreases, the rate-based quantization level Qr increases.

The second switch controller 213-4 receives the context-based quantization level Qc and the rate-based quantization level Qr and outputs a second switch signal SW2 based on Equation 5:

$$Q = \max(Q_C, Q_r) \quad (5)$$

For instance, when the context-based quantization level Qc is greater than the rate-based quantization level Qr, the second switch controller 213-4 outputs the second switch signal SW2 at a first level. Accordingly, the third switch circuit 213-5 transmits the context-based quantization level Qc calculated using Equation 3 as the final quantization level Q.

However, when the context-based quantization level Qc is less than the rate-based quantization level Qr, the second switch controller 213-4 outputs the second switch signal SW2 at a second level. Accordingly, the third switch circuit 213-5 transmits the rate-based quantization level Qr calculated using Equation 4 as the final quantization level Q.

The difference between the levels Qc and Qr in a region having a low context complexity may be large. However, the consistency of the final quantization level Q may not necessarily be guaranteed in a region having a low context complexity. On the contrary, when the context complexity increases, the difference between the levels Qc and Qr decreases.

The levels Qc and Qr may be the same in regions having the highest context complexity. Accordingly, the final quantization level Q maintains consistency in regions having the highest context complexity.

FIG. 7 is a conceptual diagram of operations of the quantizer 213-6 and the inverse-quantizer 213-7 illustrated in FIG. 4 according to some embodiments of the inventive concept. Referring to FIGS. 4 and 7, the quantizer 213-6 quantizes the first component cf_pre_1 of the pre-processed image data cf_pre output from the line buffer 213-2 using the final quantization level Q and outputs a quantized value "y" to the inverse-quantizer 213-7 and the coding circuit 215 based on the quantization result.

The inverse-quantizer 213-7 inverse-quantizes the quantized value "y" using the final quantization level Q and outputs the first component compressed data cf_compress_1 to the DCC controller 600 based on the inverse-quantization result.

As shown in FIG. 7, when the first component ci_pre_1 of the pre-processed image data cf_pre is 8 bits A, B, C, D, E, F, G, and H and the final quantization level Q is 3, the quantizer 213-6 discards the lower three bits F, G, and H, as many as the final quantization level Q (=3), and outputs the upper five bits A, B, C, D, and E, i.e., the quantized value "y". The inverse-quantizer 213-7 adds as many 0s as the final quantization level Q (=3) to the five bits A, B, C, D, and E, i.e., the quantized value "y" to inverse-quantize the quantized value "y" and outputs the first component compressed data cf_compress_1 to the DCC controller 600. For instance, each value of 8 bits A, B, C, D, E, F, G, and H means binary value.

Referring back to FIG. 4, the coding circuit 215 includes a fourth switch circuit 215-1, a third switch controller 215-2, a first coder 215-3, a second coder 215-4, a fifth switch circuit 215-5, and the accumulator 215-6.

The fourth switch circuit 215-1 transmits the quantized value "y" to the first coder 215-3 or the second coder 215-4 in response to a third switch signal SW3.

FIG. 8 is a conceptual diagram of operations of the third switch controller 215-2 illustrated in FIG. 4 according to some embodiments of the inventive concept. As shown in FIGS. 5 and 8, the third switch controller 215-2 receives values "a", "b", "c", and "d" of the respective neighboring pixels P8, P4, P3, and P5 of the current pixel CP. The third switch controller 215-2 outputs the third switch signal SW3 at a first level when the received values "a", "b", "c", and "d" are the same and outputs the third switch signal SW3 at a second level when the received values "a", "b", "c", and "d" are not the same.

The fourth switch circuit 215-1 transmits the quantized value "y" to the second coder 215-4 in response to the third switch signal SW3 at the first level and transmits the quantized value "y" to the first coder 215-3 in response to the third switch signal SW3 at the second level.

The first coder 215-3 may be implemented by a Golomb coder that can perform Golomb coding. The second coder 215-4 may be implemented by a run length coder that can perform run-length coding.

The Golomb coder 215-3 performs Golomb coding on the quantized value "y" and transmits the first component bitstream cf_bitstream_1 to the fifth switch circuit 215-5 according to the Golomb coding result.

FIG. 9 is a conceptual diagram of operations of the Golomb coder 215-3 illustrated in FIG. 4 according to some embodiments of the inventive concept. Referring to FIG. 9, the Golomb coder 215-3 includes an activity computation circuit 215-3a, a k-computation circuit 215-3b, and a Golomb encoder 215-3c.

The activity computation circuit 215-3a calculates differences between two values in pairs among the values "a", "b", "c", and "d" of the respective neighboring pixels P8, P4, P3, and P5 of the current pixel CP and calculates activity using the calculation result and Equation 6:

$$\text{activity} = |d - b| + |b - c| + |c - a| \tag{6}$$

The k-computation circuit 215-3b may calculate a value "k" corresponding to the activity using Equation 7:

$$k = \begin{cases} 0\ (when\quad activity\ <= activity0) \\ 1\ (when\quad activity\ <= activity1) \\ 2\ (when\quad activity\ <= activity2) \\ \quad\quad\quad\quad \dots \\ \text{k_MAX} \quad\quad \text{otherwise} \end{cases} \tag{7}$$

where the variables activity0, activity1, activity2, ..., and k_MAX are predetermined values, activity0<activity1, and activity1<activity2.

When the activity increases, the value "k" also increases. When the activity decreases, the value "k" also decreases.

The Golomb encoder 215-3c encodes the quantized value "y" of the current pixel CP using the value "k" and outputs the first component bitstream cf_bitstream_1 based on the encoding result.

As shown in FIG. 9, when the quantized value "y" is "ABCDE" and the value "k" is 2, the Golomb encoder 215-3c outputs the first component bitstream cf_bitstream_1 including different bits based on the values of ABC.

For instance, when ABC is "000", the Golomb encoder 215-3c outputs "1DE" as the first component bitstream cf_bitstream_1. When ABC is "100", the Golomb encoder 215-3c outputs "00001DE" as the first component bitstream cf_bitstream_1. When ABC is "111", the Golomb encoder 215-3c outputs "00000001DE" as the first component bitstream cf_bitstream_1. As shown in FIG. 9, when the value "k" is 2, "DE" is a binary part, "ABC" is a unary part, and "1" is a separation bit.

Referring back to FIG. 4, the run length coder 215-4 performs run-length coding on the quantized value "y" and transmits the first component bitstream cf_bitstream_1 to the fifth switch circuit 215-5 based on the coding result.

The fifth switch circuit 215-5 transmits the first component bitstream cf_bitstream_1 from the run length coder 215-4 to the accumulator 215-6 and the second switch circuit 250 in response to the third switch signal SW3 at the first level. The accumulator 215-6 accumulates the first component bitstream cf_bitstream_1 output from the fifth switch circuit 215-5 and outputs the first component accumulated bits bits_used_1 generated based on the accumulation result to the rate-based quantization level determination circuit 213-3.

FIG. 10 is a block diagram of one of the CBR encoders 231-1 through 231-m illustrated in FIG. 2. Referring to FIG. 10, the CBR encoders 231-1 through 231-m, switching between the first encoder block 210, and the second encoder block 230 are used in the hybrid encoder 200 in order to obtain the desired compression ratio for a CBR unit.

The structures and the operations of the CBR encoders 231-1 through 231-m illustrated in FIG. 2 are the same. Thus, for convenience of description, the structure and the operation of the first CBR encoder 231-1 will be described in detail.

The first CBR encoder 231-1 includes a context-based quantization level determination circuit 213-1’, a sixth switch circuit 233-1, a fourth switch controller 233-2, a first quantizer 233-3, a first inverse-quantizer 233-4, a seventh switch circuit 233-5, an eighth switch circuit 233-6, an averaging circuit 233-7, a second quantizer 233-8, and a second inverse-quantizer 233-9.

The structure and the operation of the quantizers 233-3 and 233-8 are the same as those of the quantizer 213-6 described with reference to FIGS. 4 and 7. The structure and the operation of the inverse-quantizers 233-4 and 233-9 are the same as those of the inverse-quantizer 213-7 described with reference to FIGS. 4 and 7. The structure and the operation of the context-based quantization level determination circuit 213-1’ are the same as those of the context-based quantization level determination circuit 213-1 illustrated in FIG. 4.

The fourth switch controller 233-2 outputs a fourth switch signal SW4 based on a context-based quantization level Qc output from the context-based quantization level determination circuit 213-1’. For instance, when the context-based quantization level Qc is the maximum quantization level Q_MAX, the fourth switch controller 233-2 outputs the fourth switch signal SW4 at a first level.

In response to the fourth switch signal SW4 at the first level, the sixth switch circuit 233-1 transmits the first component cf_pre_1 of the pre-processed image data cf_pre output from a line buffer 213-2’ to the first quantizer 233-3.

The first quantizer 233-3 quantizes the first component cf_pre_1 based on the maximum quantization level Q_MAX and outputs a quantized value y1 to the first inverse-quantizer 233-4 and the eighth switch circuit 233-6. The first inverse-quantizer 233-4 inverse-quantizes the quantized value y1 output from the first quantizer 233-3 based on the maximum quantization level Q_MAX and outputs the first component compressed data cf_compress_1 generated according to the result of the inverse-quantization to the seventh switch circuit 233-5.

In response to the fourth switch signal SW4 at the first level, the seventh switch circuit 233-5 transmits the first component compressed data cf_compress_1 to the second switch circuit 250. In response to the fourth switch signal SW4 at the first level, the eighth switch circuit 233-6 transmits the quantized value y1 output from the first quantizer 233-3 to the second switch circuit 250 as the first component bitstream cf_bitstream_1.

However, when the context-based quantization level Qc is not the maximum quantization level Q_MAX, the fourth switch controller 233-2 outputs the fourth switch signal SW4 at a second level. In response to the fourth switch signal SW4 at the second level, the sixth switch circuit 233-1 transmits the first component cf_pre_1 of the pre-processed image data cf_pre output from the line buffer 213-2’ to the averaging circuit 233-7.

The averaging circuit 233-7 receives a pixel value y’ of the current pixel CP of the first component cf_pre_1 and a pixel value NV of a next pixel NP of the first component cf_pre_1 from the line buffer 213-2’, calculates an average of the values y’ and NV, and outputs an average pixel value.

The second quantizer 233-8 quantizes values output from the averaging circuit 233-7 based on a quantization level Qc (=Q_MAX-1) and outputs a quantized value y2 to the second inverse-quantizer 233-9 and the eighth switch circuit 233-6. The second inverse-quantizer 233-9 inverse-quantizes the quantized value y2 output from the second quantizer 233-8 based on the quantization level Qc (=Q_MAX-1) and outputs the first component compressed data cf_compress_1 generated according to the result of the inverse-quantization to the seventh switch circuit 233-5.

In response to the fourth switch signal SW4 at the second level, the seventh switch circuit 233-5 transmits the first component compressed data cf_compress_1 to the second switch circuit 250. In response to the fourth switch signal SW4 at the second level, the eighth switch circuit 233-6 transmits the quantized value y2 output from the second quantizer 233-8 to the second switch circuit 250 as the first component bitstream cf_bitstream_1.

A quantization level for a region having the highest context-based quantization level Qc (=Q_MAX) in the CBR encoders 231-1 through 231-m maintains consistency with a quantization level for a region having the highest context-based quantization level Qc (=Q_MAX) in the VBR encoders 211-1 through 211-m.

When the context-based quantization level Qc is less than the highest context-based quantization level Q_MAX for the current pixel CP, that is, when Qc<Q_MAX, the first component cf_pre_1 is processed by the elements 233-7 and 233-8 to reduce reconstruction errors.

FIG. 11 is a block diagram of the ordered bitstream merging circuit 260 illustrated in FIG. 2. Referring to FIGS. 2 and 11, the component bitstreams cf_bitstream_j (where j=1 through "m") respectively output from the VBR encoders 211-1 through 211-m have a variable length. Accordingly, unordered bitstream merging does not allow decoding.

The ordered bitstream merging circuit 260 merges the independent bitstreams cf_bitstream_j (where j=1 through "m") output from the first or second encoder block 210 or 230 into one current frame bitstream cf_bitstream.

The ordered bitstream merging circuit 260 includes bit buffers 260-1 through 260-m and a merging circuit 262.

The bit buffers 260-1 through 260-m temporarily store the component bit stream cf_bitstream_1 through the component bit stream cf_bitstream_m, respectively. For instance, when the sum of bits in each of the component bit stream cf_bitstream_1 through the component bit stream cf_bitstream_m and bits already been stored in a corresponding one of the bit buffers 260-1 through 260-m is less than the maximum bits bpp_MAX, the component bit stream cf_bitstream_1 through the component bit stream cf_bitstream_m are stored in the bit buffers 260-1 through 260-m, respectively, and none of them is output to the merging circuit 262.

However, when the sum of bits in each of the component bitstream cf_bitstream_1 through the component bit stream cf_bitstream_m and bits already been stored in a corresponding one of the bit buffers 260-1 through 260-m is greater than the maximum bits bpp_MAX, the bit buffers 260-1 through 260-m output the maximum bits bpp_MAX to the merging circuit 262 to be merged. At this time, the remaining bits in each of the component bit stream cf_bitstream_1 through the component bitstream cf_bitstream_m are stored in the corresponding one of the bit buffers 260-1 through 260-m.

For convenience of description, switches are illustrated in FIG. 11, but the bit buffers 260-1 through 260-m may include a switch function therewithin to output the maximum bits bpp_MAX in a component bitstream.

As described above, a merged bitstream, i.e., the current frame bitstream cf_bitstream can be decoded. The merging circuit 262 generating the current frame bitstream cf_bitstream may be implemented by a single wire or a single transmission line.

FIG. 12 is a block diagram of operations of the frame memory controller 300 illustrated in FIG. 1 according to some embodiments of the inventive concept. Referring to FIGS. 1, 2, and 12, even though the VBR encoders 211-1 through 211-m are included in the hybrid encoder 200, the pre-processed image data cf_pre is selectively transmitted to the VBR encoders 211-1 through 211-m or the CBR encoders 231-1 through 231-m, and, therefore, the desired compression ratio for a CBR unit may be maintained.

As shown in FIG. 12, the current frame cf_org is divided into N (where N is a natural number) CBR units. The frame memory 400 is divided into (N+1) frame memory units. The size of a single frame memory unit is the same as the size of a single CBR unit generated based on the desired compression ratio. In other words, a single frame memory unit stores a bitstream of a single CBR unit.

The frame memory controller 300 generates a write frame memory unit number and a read frame memory unit number.

The current frame cf_org is encoded by the hybrid encoder 200. A bitstream of a CBR unit is stored in a frame memory unit in the frame memory 400 according to the control of the frame memory controller 300. At the same time, a bitstream of a CBR unit in a previous frame, which has already been stored in another frame memory unit in the frame memory 400, is read and transmitted to the hybrid decoder 500 according to the control of the frame memory controller 300.

The hybrid decoder 500 decodes the bitstream of the CBR unit, which has been read, and outputs decoded data, i.e., the previous frame compressed data pf_compress.

The bitstream of a CBR unit in the current frame cf_org is not written to a frame memory unit that has stored a corresponding CBR unit in a previous frame, so that overwriting is avoided in the frame memory 400.

FIG. 13 is a block diagram of the memory allocation in the frame memory 400 illustrated in FIG. 1. FIG. 13 exemplary shows one of various memory allocation methods provided to avoid overwriting in the frame memory 400.

As shown in FIG. 13, a write operation and a read operation are not simultaneously performed on one frame memory unit in the frame memory 400 for each frame.

FIG. 14 is a block diagram of the DCC controller 600 illustrated in FIG. 1. The DCC controller 600 includes a first stage compensation circuit 610 and a second stage compensation circuit 630.

The first stage compensation circuit 610 generates a previous frame base reference value pf_ref_base based on the current frame cf_org and the previous frame compressed data pf_compress and generates a final smoothness level "s1" based on the current frame cf_org.

The first stage compensation circuit 610 includes a motion estimation circuit 612, a smoothness level determination circuit 614, and a base reference value determination (BRVD) circuit 616.

Motion estimation is used to reduce the effect of variations in a previous frame reconstructed value pf_rec on the image quality due to an inconsistent quantization level.

FIG. 15 is a block diagram of the motion estimation circuit 612 illustrated in FIG. 14. The motion estimation circuit 612 includes a quantizer 612-1, a comparator 612-2, and a tuned reconstructed value determination circuit 612-3.

The quantizer 612-1 receives the current frame cf_org and the quantization level pf_Q included in the previous frame compressed data pf_compress, quantizes a pixel value "cf_org_i±Noise" of the current pixel "i" (FIG. 6) included in the current frame cf_org on which the noise has been inflicted, and outputs a quantized value obtained as a result of the quantization to the comparator 612-2.

The comparator 612-2 compares the quantized value received from the quantizer 612-1 with the reconstructed value pf_rec included in the previous frame compressed data pf_compress and outputs "1" or "0" as a motion matched flag matched_flag_i for the current pixel "i" according to the comparison result. For instance, when the quantized value is the same as the reconstructed value pf_rec, the comparator 612-2 outputs "1" as the motion matched flag matched_flag_i for the current pixel "i". In other cases, the comparator 612-2 outputs "0" as the motion matched flag matched_flag_i for the current pixel "i".

The comparator 612-2 computes the motion matched flag matched_flag_i for the pixel value cf_org_i of the current pixel "i" in the current frame cf_org using Equation 8:

$$matched_flag_i = (Quantization(cf_org_i \pm Noise), pf_Q) == pf_rec)\ ?\ 1:0 \qquad (8)$$

where Quantization() is a function expressing the operation of the quantizer 612-1. The operation of the quantizer 612-1 is the same as one described with reference to FIG. 7. For instance, when the pixel value "cf_org_i±Noise" is 8 bits, i.e., "ABCDEFGH" and the quantization level pf_Q is 3, Quantization (cf_org_i±Noise, pf_Q) is ABCDE. In Equation 8, "Noise" is noise that may occur in an actual use environment and may occur during the transmission of the current frame cf_org.

Even when the pixel value cf_org_i of the current pixel "i" in the current frame cf_org is the same as a pixel value pf_org_i of a corresponding pixel in the previous frame, the two values cf_org_i and the pf_org_i may be different from each other due to noise. In this case, Quantization (cf_org_i, pf_Q) may not be the same as the reconstructed value pf_rec, and therefore, the noise is added as shown in Equation 8. In other words, Quantization (cf_org_i±Noise, pf_Q) eliminates or may reduce inconsistency in motion estimation caused by noise.

The tuned reconstructed value determination circuit 612-3 determines a previous frame tuned reconstructed value pf_rec_tuned using Equation 9:

$$pf_rec_tuned = (matched_flag_0{==}1 | \ldots matched_flag_i{==}1 | \ldots)\ ?\ A : B$$

$$A = \frac{matched_flag_0 \times cf_org_0 + \ldots + matched_flag_i \times cf_org_i + \ldots}{matched_flag_0 + \ldots + matched_flag_i + \ldots}$$

$$B = pf_rec \qquad (9)$$

where "|" indicates an OR operation. Accordingly, when motion matched flags {matched_flag_i} are all "0", the tuned reconstructed value determination circuit 612-3 determines the previous frame reconstructed value pf_rec as the previous frame tuned reconstructed value pf_rec_tuned. When the motion matched flags {matched_flag_i} are not all "0", the tuned reconstructed value determination circuit 612-3 determines an average of values of pixels which are found matched with the previous frame reconstructed value pf_rec within a search range SR as the previous frame tuned reconstructed value pf_rec_tuned.

FIG. 16 is a diagram of the search range SR used in the motion estimation circuit 612 illustrated in FIG. 14. Demand on a line buffer for storing pixel value of each of pixels in the search range SR and computation complexity rapidly increase as the search range SR, which is predetermined for the motion estimation, increases. Accordingly, the search range SR needs to be selected appropriately.

Human eyes are sensitive to distortions in smooth regions but insensitive in detailed regions. Final quantization levels are consistent in regions having the highest context complexity but are not consistent in regions having low context complexity.

While good response speed is maintained for an LCD, a smooth level may be used to generate the previous frame base reference value pf_ref_base.

FIGS. 17A through 17C are conceptual diagrams of operations of the smoothness level determination circuit 614 illustrated in FIG. 4 according to some embodiments of the inventive concept. As shown in FIG. 17A, because distortions in a real smooth region or a clear edge are visible to human eyes, the real smooth region and the clear edge are defined as smooth regions.

FIG. 17B shows an example of a region including four pixels "m", "n", "i", and "j". The smoothness level determination circuit 614 calculates a smooth level "sld()" for each of regions including a current pixel of the current frame cf_org and outputs a minimum value among smooth levels "sld()" for the respective regions as the final smooth level "sl".

FIG. 17C shows eight cases to explain a method of determining the final smooth level "sl" for the current pixel of the current frame cf_org. The smoothness level determination circuit 614 determines the smooth level "sld()" for each region using Equation 10:

$$sld(m,n,i,j) = \begin{cases} 0 \ (when \ \ diff(m,n) <= th(m,n) \&\& \ diff(i,j) <= th(i,j)) \\ 1 \ (when \ \ diff(m,n) <= th(m,n) + bias1 \ \&\& \ diff(i,j) <= th(i,j) + bias1) \\ 2 \ (when \ \ diff(m,n) <= th(m,n) + bias2 \ \&\& \ diff(i,j) <= th(i,j) + bias2) \\ \quad\quad\quad\quad\quad\quad\quad\quad\quad\quad \cdots \\ \text{sld_MAX} \quad\quad\quad \text{otherwise} \end{cases} \tag{10}$$

where "sld()" is a smooth level for checking each case, "diff()" is a difference between pixel values of two respective neighboring pixels, "th()" is a pixel value dependent on threshold voltages, and bias1, bias2, ..., and sld_MAX are predetermined values.

The smoothness level determination circuit 614 determines the final smooth level "sl" using Equation 11:

$$\text{sl} = \min_{\text{t cases}} (\{\text{sld}(\,)\}) \tag{11}$$

FIG. 17C shows eight cases (t-cases; t=8). In FIG. 17C, "diff()" is the difference between two pixels connected with a solid line.

The BRVD circuit 616 generates the previous frame base reference value pf_ref_base based on the previous frame tuned reconstructed value pf_rec_tuned and the motion matched flags {matched_flag_i}, which are received from the motion estimation circuit 612, and the final smooth level "sl" received from the smoothness level determination circuit 614. The BRVD circuit 616 calculates the previous frame base reference value pf_ref_base using Equation 12:

$$\text{if}\,(\text{matched_flag_0}\,|\,\ldots\,|\text{matched_flag_i}|\,\ldots)\ \text{pf_rec_base} = \text{pf_rec_tuned}$$

$$\text{else}\,\{$$

$$weight = \begin{cases} 0\ (\text{when}\ \ |\text{pf_rec_tuned} - \text{cf_org_search_range}|\ <= \text{th0}\ \&\&\ \text{sl}\ <= \text{sl0}) \\ 1\ (\text{when}\ \ |\text{pf_rec_tuned} - \text{cf_org_search_range}|\ <= \text{th1}\ \&\&\ \text{sl}\ <= \text{sl1}) \\ 2\ (\text{when}\ \ |\text{pf_rec_tuned} - \text{cf_org_search_range}|\ <= \text{th2}\ \&\&\ \text{sl}\ <= \text{sl2}) \\ \ldots \\ \text{weight_MAX} \qquad \text{otherwise} \end{cases}$$

$$\text{pf_ref_base} = \frac{\text{pf_rec_tuned} * \text{weight} + \text{cf_org_search_range} * (\text{weigth_MAX} - \text{weight})}{\text{weigth_MAX}}$$

$$\} \qquad (12)$$

When any one of the motion matched flags {matched_flag_i} is "1", the BRVD circuit 616 outputs the previous frame tuned reconstructed value pf_rec_tuned as the previous frame base reference value pf_ref_base. In other cases, the BRVD circuit 616 calculates the previous frame base reference value pf_ref_base based on the weighted summation of an original value cf_org_search_range of the current frame cf_org within the search range SR (FIG. 16) and the previous frame tuned reconstructed value pf_rec_tuned.

As shown in Equation 12, a weight is related with the final smooth level "sl" and the difference between the previous frame tuned reconstructed value pf_rec_tuned and the original value cf_org_search_range.

The second stage compensation circuit 630 calculates the previous frame reference value pf_ref based on the current frame cf_org, the previous frame compressed data pf_compress, and the previous frame base reference value pf_ref_base.

The second stage compensation circuit 630 includes a still detection circuit 632, a movement level determination circuit 634, and a final reference value determination (FRVD) circuit 63 6.

The still detection circuit 632 receives the current frame cf_org and the previous frame compressed data pf_compress and determines whether there is movement between the current frame cf_org and the previous frame. For instance, when there is no movement between the current frame cf_org and the previous frame, that is, when the previous frame matches the current frame cf_org, the still detection circuit 632 outputs "1" as a still flag still_flag using Equation 13:

$$still_flag = (matched_flag_0 == 1)?\ 1:0 \qquad (13)$$

The movement level determination circuit 634 receives the previous frame base reference value pf_ref_base, the current frame cf_org, the still flag still_flag, the current frame compressed data cf_compress, the previous frame compressed data pf_compress, and the final smooth level "sl" and calculates a movement level "ml" using Equation 14:

$$\begin{aligned}&\text{if}(still_flag == 1)\ ml = 0;\\ &else\{\\ &\quad ml = |cf_org_0 - pf_ref_base| + tuning(sl);\\ &\quad \text{if}\ (ml > ml_MAX)\ \ ml = ml_MAX\\ &\}\end{aligned} \qquad (14)$$

For instance, when the still flag still_flag is "1", the movement level "ml" is "0". In other cases, the movement level "ml" is dependent on a difference between an original value cf_org_0 of a pixel corresponding to a pixel of the previous frame in the current frame cf_org and the previous frame base reference value pf_ref_base and a tuning value "tuning(sl)". The tuning value "tuning(sl)" is determined by the final smooth level "sl" as shown in Equation 15;

$$tuning(sl) = \begin{cases} 0\ (when\quad sl\ <= sl0) \\ 1\ (when\quad sl\ <= sl1) \\ 2\ (when\quad sl\ <= sl2) \\ \dots \\ \text{tuning_MAX} \quad \text{otherwise} \end{cases} \tag{15}$$

Referring to Equation 15, because distortion is difficult to detect in detailed regions, the tuning value "tuning(sl)" gets higher in regions having higher context complexity. In Equations 14 and 15, a maximum movement level ml_MAX, reference constants sl0, sl1, sl2, ..., and a maximum tuning value tuning_MAX are predetermined values.

The FRVD circuit 636 receives the previous frame base reference value pf_ref_base, the current frame cf_org, and the movement level "ml" and calculates the previous frame reference value pf_ref using Equation 16:

$$\text{pf_ref} = \begin{cases} \text{cf_org_cp_val} + \dfrac{\text{pf_ref_base} - \text{cf_org_cp_val}}{\text{ml_MAX}} \times \text{ml (when} \quad \text{ml} <= \text{ml_MAX)} \\ \text{pf_ref_base (when} \quad \text{ml} > \text{ml_MAX)} \end{cases} \tag{16}$$

FIG. 18 is a diagram of the overdrive table 801 illustrated in FIG. 1 according to some embodiments of the inventive concept.

As expressed in Equation 16, when the movement level "ml" is "0", the previous frame reference value pf_ref is the same as a current frame current pixel value cf_org_cp_val (i.e., a pixel value of the current pixel CP in the current frame cf_org). In this case, there is no effect of overdrive. In other words, as shown in FIG. 18, when the previous frame reference value pf_ref and the current frame current pixel value cf_org_cp_val are both 128, the search value tbl_value is also 128.

When the movement level "ml" is the maximum movement level ml_MAX, the previous frame reference value pf_ref is the same as the previous frame base reference value pf_ref_base. In this case, because the movement level "ml" is a maximum level, the effect of overdrive is maximized.

When the movement level "ml" is in between "0" and the maximum movement level ml_MAX, the previous frame reference value pf_ref is a value of the linear combination of the current frame current pixel value cf_org_cp_val and the previous frame base reference value pf_ref_base.

As shown in FIG. 18, the overdrive table 801 includes search value or overdrive pixel value corresponding to the previous frame reference value pf_ref and the current frame current pixel value cf_org_cp_val. When the previous frame reference value pf_ref is 128 and the current frame current pixel value cf_org_cp_val is 128, the search value tbl_value is 128 and the overdrive pixel value is also 128. Accordingly, over-shoot or under-shoot is not necessary.

When the previous frame reference value pf_ref is 64 and the current frame current pixel value ci_org_cp_val is 192, the search value tbl_value is 220 and the overdrive pixel value is also 220. Accordingly, over-shoot is necessary.

When the previous frame reference value pf_ref is 192 and the current frame current pixel value cf_org_cp_val is 64, the search value tbl_value is 40 and the overdrive pixel value is also 40. Accordingly, under-shoot is necessary.

When the previous frame reference value pf_ref is 34 and the current frame current pixel value cf_org_cp_val is 56, search values tbl_value are OD1, OD2, OD3, and OD4. The table search controller 700 interpolates the search values tbl_value, i.e., OD1, OD2, OD3, and OD4, to generate the overdrive pixel value. At this time, the table search controller 700 may use linear interpolation.

FIG. 19 is a diagram of examples of the display system 100 including the display controller 110 illustrated in FIG. 1. Referring to FIGS. 1 through 19, the display system 100 includes the display controller 110 including the hybrid image compression circuit 111, the display 120, a central processing unit (CPU) 130, and a memory 140.

The display controller 110 determines whether to overdrive (e.g., overshoot or undershoot) the pixel value of a current pixel in a current frame for the fast response of the display 120, e.g., an LCD.

The CPU 130 controls the operation of the display system 100. The memory 140 functions as a data source that provides a previous frame or a current frame for the display controller 110. The memory 140 may be implemented by a volatile memory device or a non-volatile memory device.

FIG. 20 is a flowchart of a method of operating the display system 100 illustrated in FIGs. 1 and 19 according to some embodiments of the inventive concept. Referring to FIGS. 1 through 20, the hybrid image compression circuit 111 compresses the current frame cf_org using a VBR encoding method or a CBR encoding method and generates the current frame compressed data cf_compress and the current frame bitstream cf_bitstream in operation S100.

The hybrid image compression circuit 111 writes the current frame bitstream cf_bitstream to the frame memory 400 and simultaneously reads the previous frame bitstream pf_bitstream from the frame memory 400 in operation S110. The hybrid image compression circuit 111 decodes the previous frame bitstream pf_bitstream and generates the previous frame compressed data pf_compress in operation S120.

The hybrid image compression circuit 111 generates the previous frame reference value pf_ref based on the current frame cf_org, the current frame compressed data cf_compress, and the previous frame compressed data pf_compress in operation S130. The hybrid image compression circuit 111 outputs the current overdriven frame cf_od including an overdrive pixel value for a current pixel based on the current frame current pixel value cf_org_cp_val and the previous frame reference value pf_ref in operation S140. The LCD 120 displays the current overdriven frame cf_od output from the hybrid image compression circuit 111.

As described above, according to some embodiments of the inventive concept, an image compression circuit provides a desired compression ratio for the fast response of an LCD and accomplishes a high compression ratio without data truncation.

While the inventive concept has been particularly shown and described with reference to exemplary embodiments thereof, it will be understood by those of ordinary skill in the art that various changes in forms and details may be made therein without departing from the spirit and scope of the inventive concept as defined by the following claims.

## Claims

**1.** An image compression circuit comprising:

an encoder configured to compress a current frame and to output current frame compressed data and a current frame bitstream;
a frame memory controller configured to write the current frame bitstream to a frame memory and simultaneously read a previous frame bitstream from the frame memory;
a decoder configured to decode the previous frame bitstream and to output previous frame compressed data;
a dynamic capacitance compensation controller configured to output a previous frame reference value based on the current frame, the current frame compressed data, and the previous frame compressed data; and
an overdrive circuit configured to generate a current overdriven frame comprising an overdrive pixel value for a current pixel based on a pixel value of the current pixel in the current frame and the previous frame reference value.

**2.** The image compression circuit of claim 1, wherein the encoder compresses the current frame using one of a variable bit rate encoding method and a constant bit rate encoding method and outputs the current frame compressed data and the current frame bitstream.

**3.** The image compression circuit of claim 1, wherein the encoder comprises:

a pre-processing circuit configured to pre-process the current frame and to output pre-processed image data;
a plurality of variable bit rate encoders configured to encode components comprised in the pre-processed image data at a variable bit rate;
a plurality of constant bit rate encoders configured to encode the component at a constant bit rate;
a first switch circuit configured to transmit the components to the variable bit rate encoders or the constant bit rate encoders in response to a first switch signal;
a second switch circuit configured to transmit component compressed data and a component bitstream, which are received from the variable bit rate encoders or the constant bit rate encoders, in response to the first switch signal;
an accumulator configured to generate all-component accumulated bits by accumulating component bitstreams output for the respective components from the second switch circuit;
a first switch controller configured to generate the first switch signal based on the all-component accumulated bits; and
an ordered bitstream merging circuit configured to generate the current frame bitstream by merging the component bitstreams for the respective components output from the second switch circuit, and
wherein the current frame compressed data comprises the component compressed data for each of the components.

**4.** The image compression circuit of claim 3, wherein each of the variable bit rate encoders comprises:

a quantization circuit configured to generate a quantized value by quantizing a corresponding one of the components based on a final quantization level and to generate the component compressed data for the corresponding component by inverse-quantizing the quantized value; and
a coding circuit configured to generate the component bitstream for the corresponding component by encoding the quantized value using one of coders respectively performing different encoding methods.

**5.** The image compression circuit of claim 3, wherein each of the constant bit rate encoders comprises:

a context-based quantization level determination circuit configured to determine a context-based quantization level for a region comprising neighboring pixels of the current pixel for a corresponding one of the components using differences between pixel values of the respective neighboring pixels;
a second switch controller configured to generate a second switch signal based on the context-based quantization level;
a third switch circuit configured to transmit the corresponding component to one of a first quantizer and an averaging circuit based on the second switch signal;
a first inverse-quantizer configured to generate the component compressed data for the corresponding component by inverse-quantizing a first quantized value output from the first quantizer based on the context-based quantization level corresponding to a first quantization level;
a second quantizer configured to output a second quantized value by quantizing an output signal of the averaging circuit based on the context-based quantization level corresponding to a second quantization level;
a second inverse-quantizer configured to generate the component compressed data for the corresponding component by inverse-quantizing the second quantized value based on the context-based quantization level corresponding to the second quantization level;
a fourth switch circuit configured to transmit the component compressed data from one of the first inverse-quantizer and the second inverse-quantizer to the second switch circuit based on the second switch signal; and
a fifth switch circuit configured to transmit one of the first quantized value and the second quantized value as the component bitstream for the corresponding component to the second switch circuit based on the second switch signal,
wherein the first quantizer outputs the first quantized value by quantizing the corresponding component based on the context-based quantization level corresponding to the first quantization level, and
wherein the averaging circuit calculates an average of the pixel value of the current pixel and a pixel value of a next pixel of the current pixel.

**6.** The image compression circuit of claim 3, wherein the ordered bitstream merging circuit comprises:

a plurality of bit buffers configured to store a component bitstream for each of the components; and
a merging circuit configured to merge component bitstreams for the respective components, which are output from the respective bit buffers every time when the bit buffers are full, into the current frame bitstream.

**7.** The image compression circuit of claim 1, wherein when the frame memory comprises a plurality frame memory units, the frame memory controller writes the current frame bitstream to one of the frame memory units and simultaneously reads the previous frame bitstream from another one of the frame memory units.

**8.** The image compression circuit of claim 1, wherein the dynamic capacitance compensation controller comprises:

a first stage compensation circuit configured to generate a final smoothness level based on the current frame and to generate a previous frame base reference value based on the current frame, the previous frame compressed data, and the final smoothness level; and
a second stage compensation circuit configured to generate the previous frame reference value based on the previous frame base reference value, the current frame, the current frame compressed data, the previous frame compressed data, and the final smoothness level.

**9.** The image compression circuit of claim 1, wherein the overdrive circuit comprises:

an overdrive table configured to store overdrive pixel values;
a table search controller configured to read at least one value corresponding to the pixel value of the current pixel and the previous frame reference value among the overdrive pixel values as at least one search value and to generate the current overdriven frame comprising the overdrive pixel value for the current pixel based on the at least one search value; and
a display driver interface configured to transmit the current overdriven frame to a display.

**10.** A display system comprising:

a liquid crystal display (LCD) configured to display a current overdriven frame comprising an overdrive pixel value for a current pixel; and
an image compression circuit configured to generate the current overdriven frame,
wherein the image compression circuit is the image compression circuit according to any one of claims 1 to 9.

FIG. 1

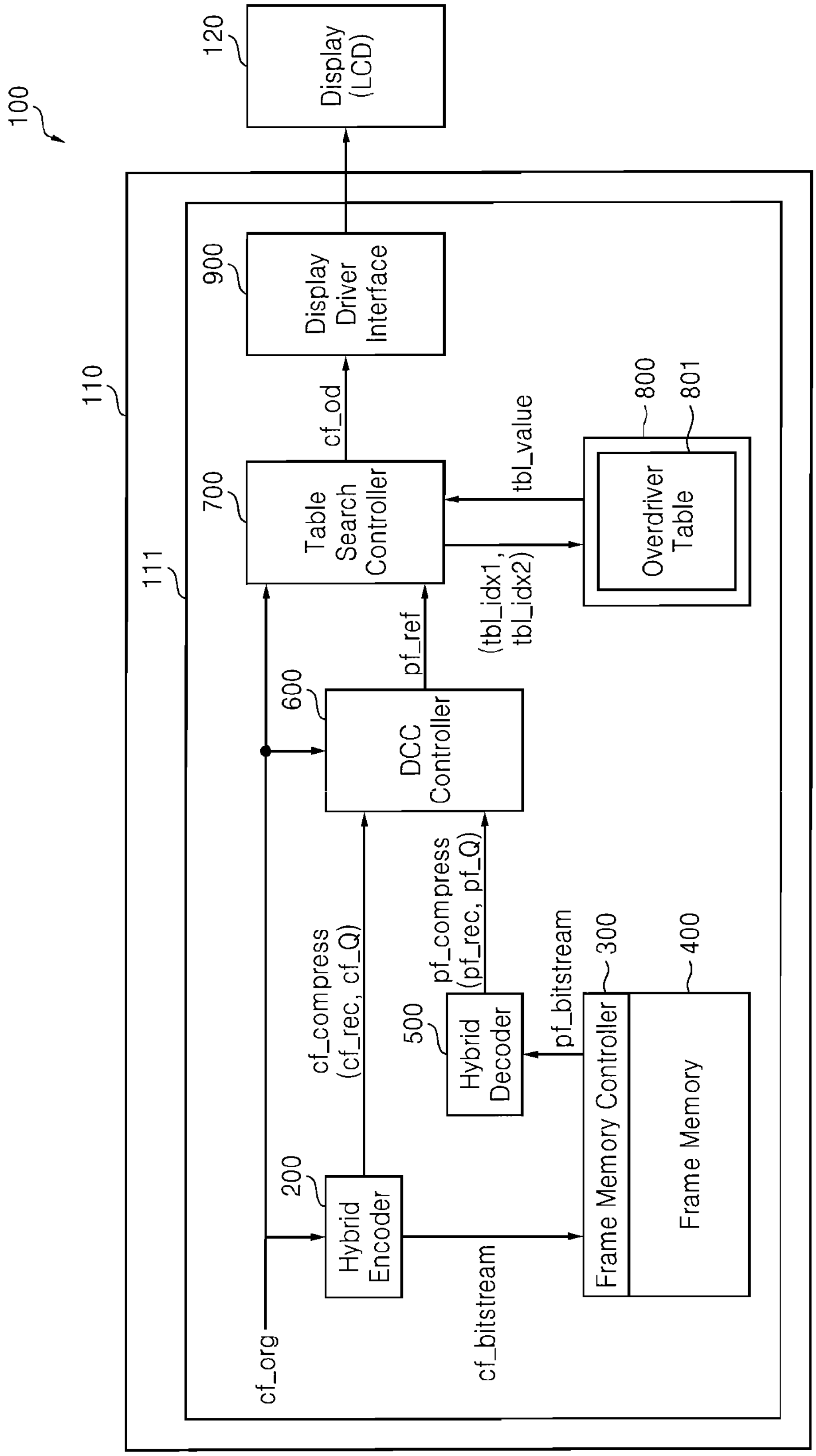
100
110
111
120
Display (LCD)
900
Display Driver Interface
cf_od
700
Table Search Controller
tbl_value
(tbl_idx1, tbl_idx2)
800
801
Overdriver Table
600
DCC Controller
pf_ref
cf_compress (cf_rec, cf_Q)
pf_compress (pf_rec, pf_Q)
500
Hybrid Decoder
pf_bitstream
300
400
Frame Memory Controller
Frame Memory
200
Hybrid Encoder
cf_org
cf_bitstream

FIG. 2

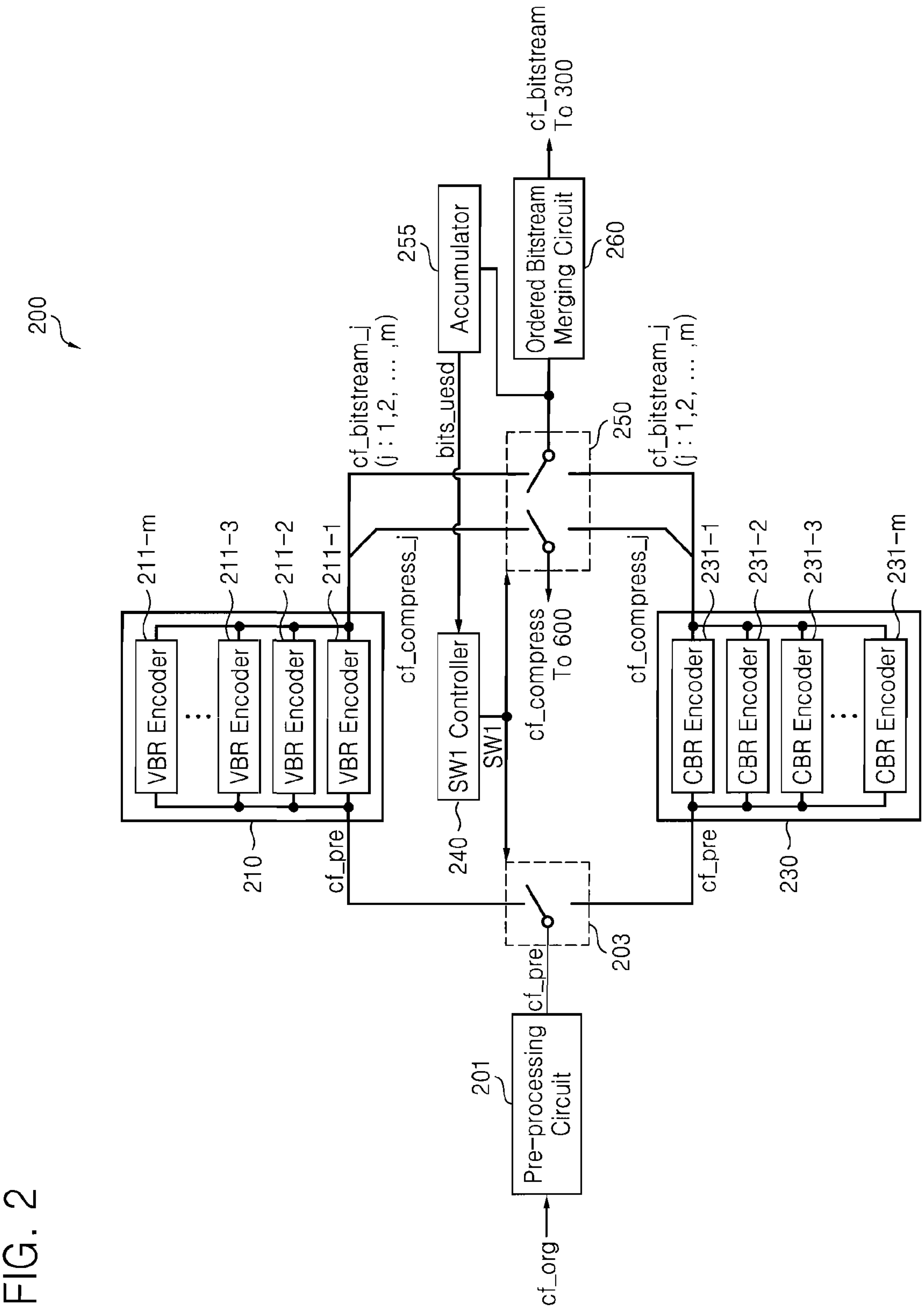

200
cf_org
Pre-processing Circuit
201
cf_pre
203
cf_pre
210
VBR Encoder
211-1
211-2
211-3
211-m
cf_compress_j
cf_bitstream_j
(j : 1,2, ... ,m)
240
SW1 Controller
SW1
bits_uesd
255
Accumulator
250
cf_compress
To 600
Ordered Bitstream Merging Circuit
260
cf_bitstream
To 300
230
CBR Encoder
231-1
231-2
231-3
231-m

FIG. 3

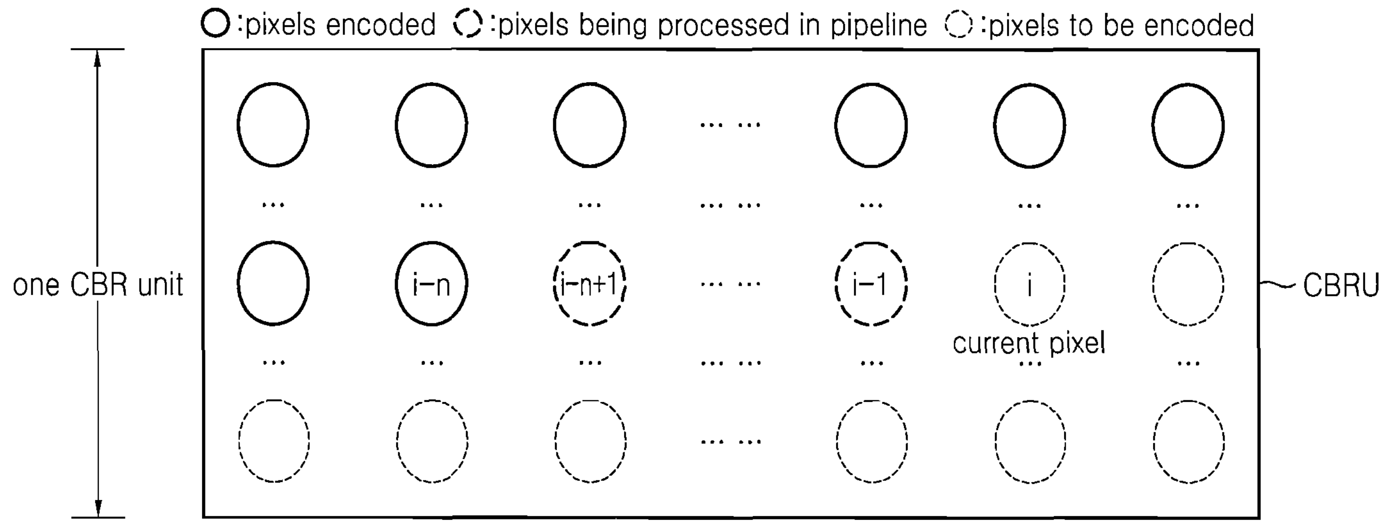


bits_used: bits used for pixels encoded in current CBR unit
bits_total: total bits available for all pixels in one CBR unit
n: the number of pipeline stages used in hardware implementation
left_pixels: the number of pixels to be encoded in current CBR unit
bpp_MAX: maximum bits required per pixel in VBR encoder and CBR encoder
bpp_CBR: allocated bits per pixel in CBR encoder
bpp_TGT: available bits per pixel under the desired compression ratio

FIG. 4

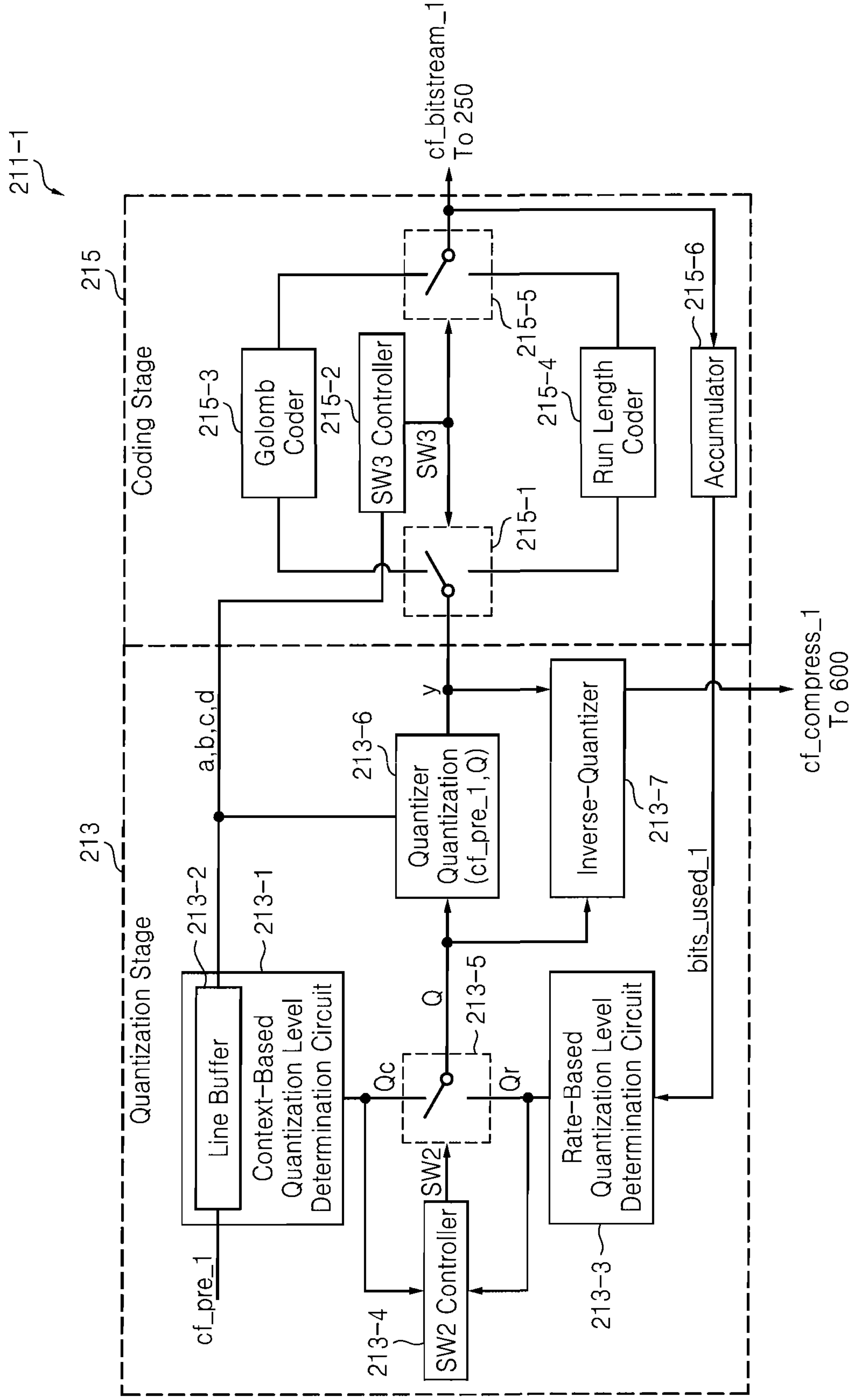
211-1
215
Coding Stage
213
Quantization Stage
cf_bitstream_1
To 250
Golomb Coder
215-3
SW3 Controller
215-2
SW3
215-5
215-1
Run Length Coder
215-4
Accumulator
215-6
a,b,c,d
y
Quantizer
Quantization
(cf_pre_1,Q)
213-6
Inverse-Quantizer
213-7
cf_compress_1
To 600
bits_used_1
Line Buffer
213-2
Context-Based
Quantization Level
Determination Circuit
213-1
Q
213-5
Qc
Qr
SW2
SW2 Controller
213-4
Rate-Based
Quantization Level
Determination Circuit
213-3
cf_pre_1

FIG. 5

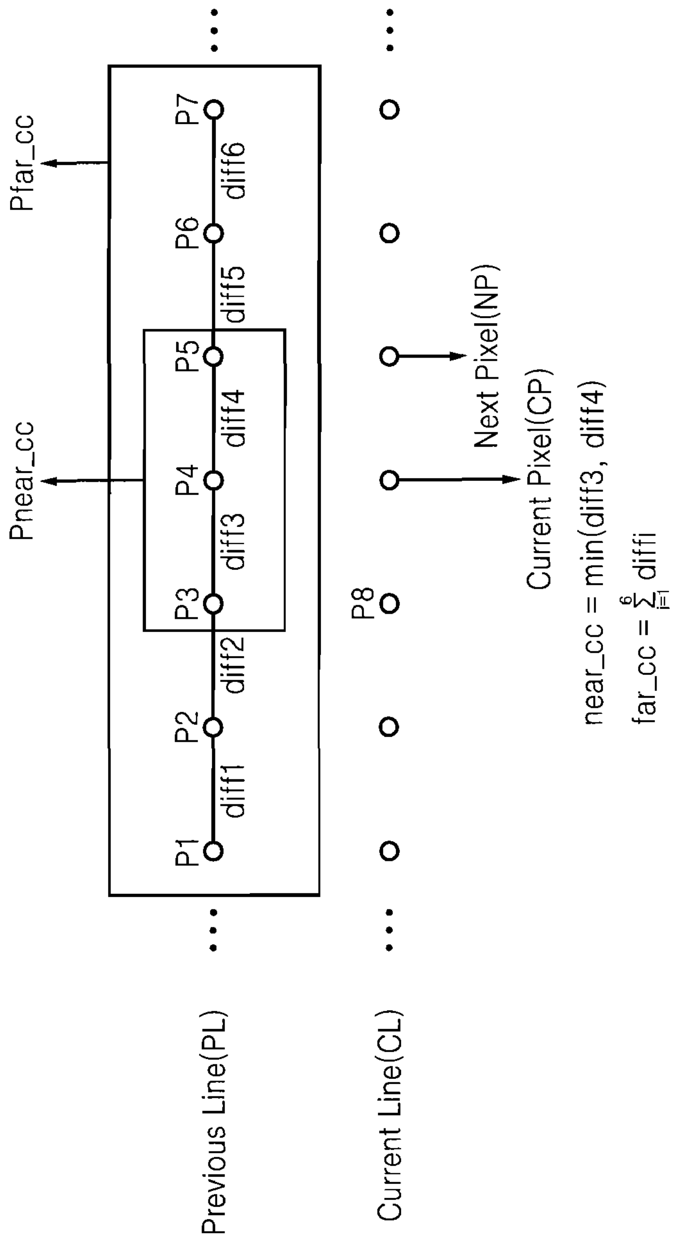
Pfar_cc
Pnear_cc
P1
P2
P3
P4
P5
P6
P7
P8
diff1
diff2
diff3
diff4
diff5
diff6
Previous Line(PL)
Current Line(CL)
Next Pixel(NP)
Current Pixel(CP)
near_cc = min(diff3, diff4)
far_cc = $\sum_{i=1}^{6}$ diffi

FIG. 6

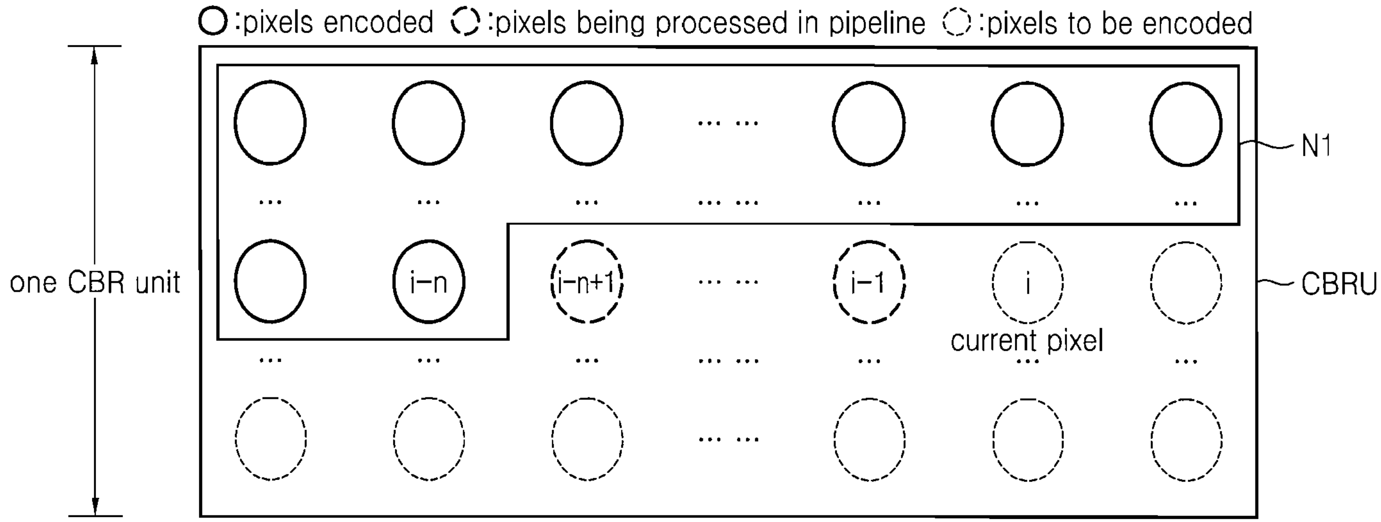


bits_used: bits used for pixels encoded in current CBR unit
budget_for_pixels_encoded: budget for pixels encoded in current CBR unit

pixels encoded = N1;
compression ratio = 1/CR;

bits_used_j = sum(cf_bitstream_j);
budget_for_pixels_encoded_j = (N1*8)*(1/CR);

FIG. 7

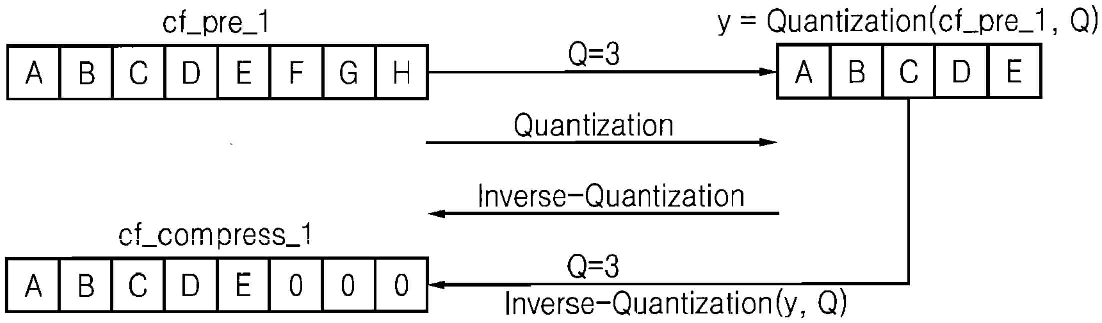
cf_pre_1
A B C D E F G H
Q=3
y = Quantization(cf_pre_1, Q)
A B C D E
Quantization
Inverse-Quantization
cf_compress_1
A B C D E 0 0 0
Q=3
Inverse-Quantization(y, Q)

FIG. 8

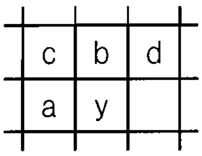


y: quantized value of current pixel
a: predicted(or reconstructed) value of previous pixel
b, c and d: reconstructed values of neighboring pixels in previous line

FIG. 9

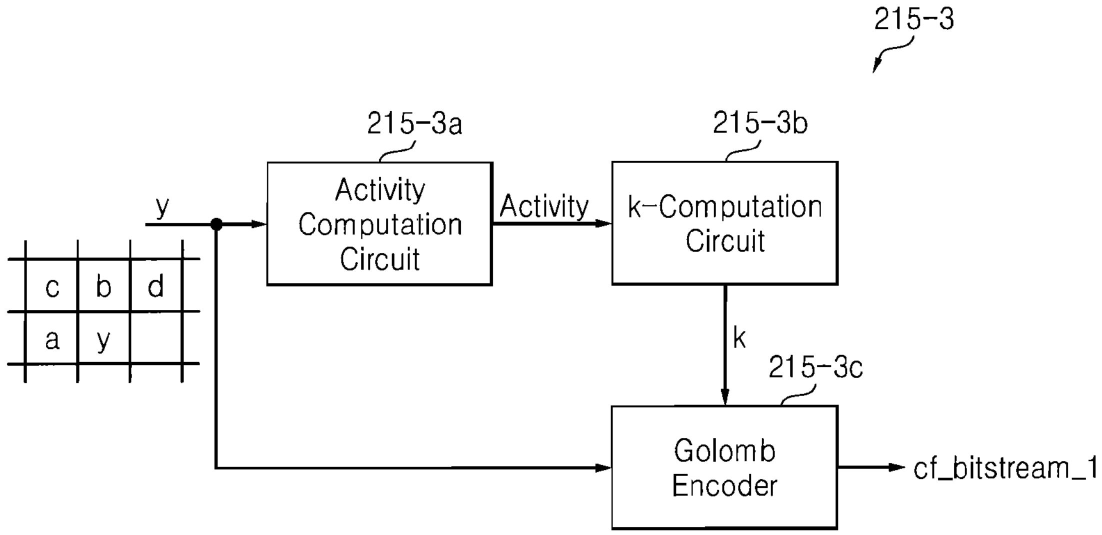


y: ABCDE

| ABC | cf_bitstream_i (when k equals to 2) |
|---|---|
| 000 | 1DE |
| 001 | 01DE |
| 010 | 001DE |
| 011 | 0001DE |
| 100 | 00001DE |
| 101 | 000001DE |
| 110 | 0000001DE |
| 111 | 00000001DE |

FIG. 10

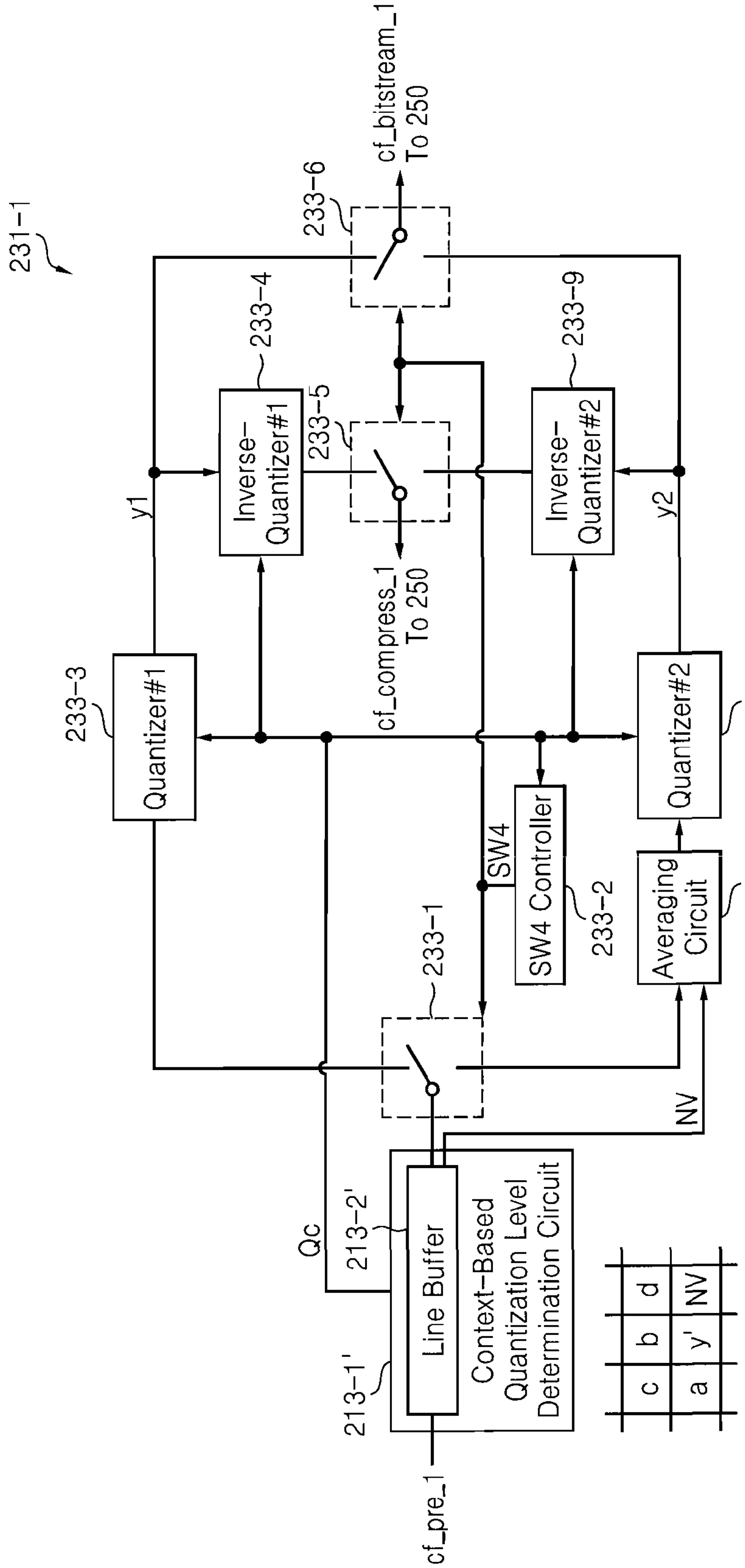
231-1
cf_bitstream_1
To 250
233-6
233-4
233-5
233-9
Inverse-
Quantizer#1
Inverse-
Quantizer#2
y1
y2
cf_compress_1
To 250
233-3
Quantizer#1
Quantizer#2
233-8
SW4
SW4 Controller
233-2
Averaging
Circuit
233-7
233-1
NV
Qc
213-2'
Line Buffer
213-1'
Context-Based
Quantization Level
Determination Circuit
cf_pre_1
c
b
d
a
y'
NV

FIG. 11

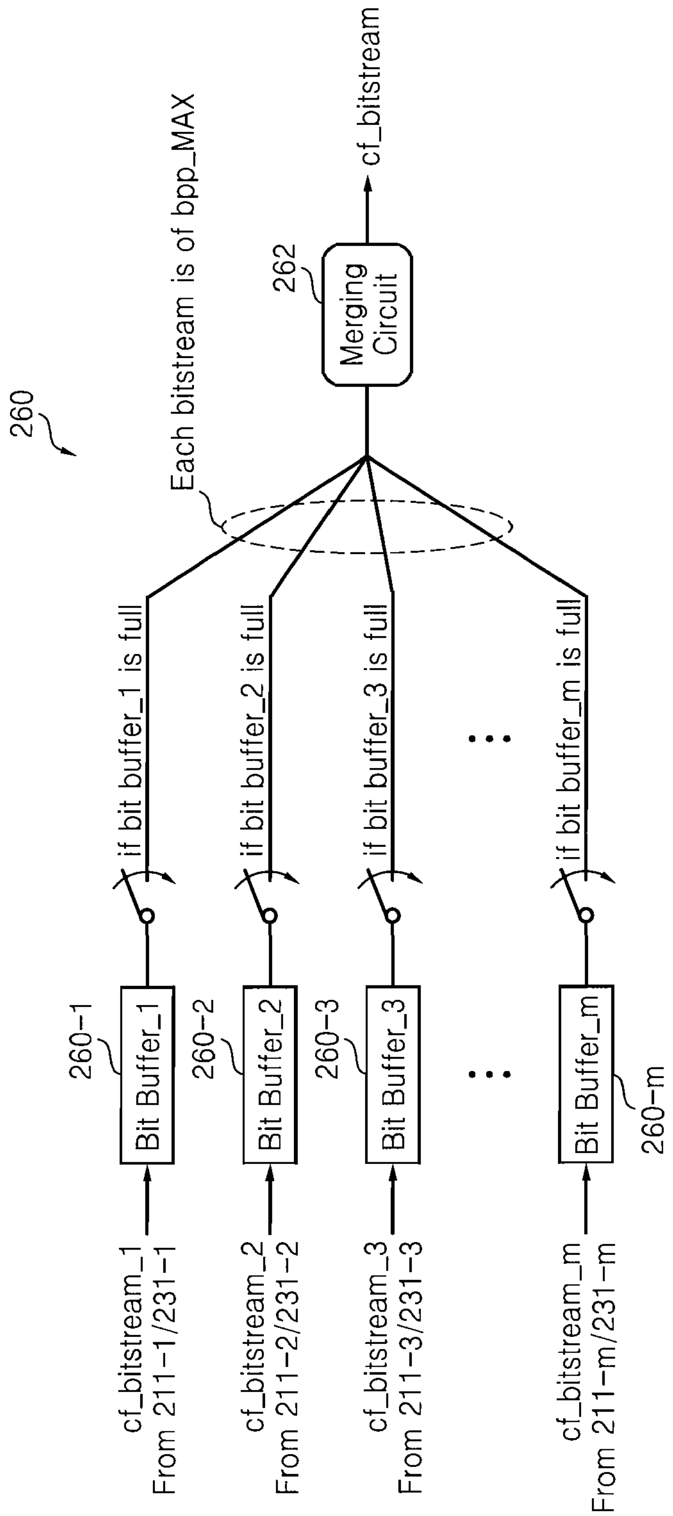
260
cf_bitstream_1
From 211−1/231−1
cf_bitstream_2
From 211−2/231−2
cf_bitstream_3
From 211−3/231−3
cf_bitstream_m
From 211−m/231−m
260−1
Bit Buffer_1
260−2
Bit Buffer_2
260−3
Bit Buffer_3
Bit Buffer_m
260−m
if bit buffer_1 is full
if bit buffer_2 is full
if bit buffer_3 is full
if bit buffer_m is full
Each bitstream is of bpp_MAX
262
Merging Circuit
cf_bitstream

FIG. 12

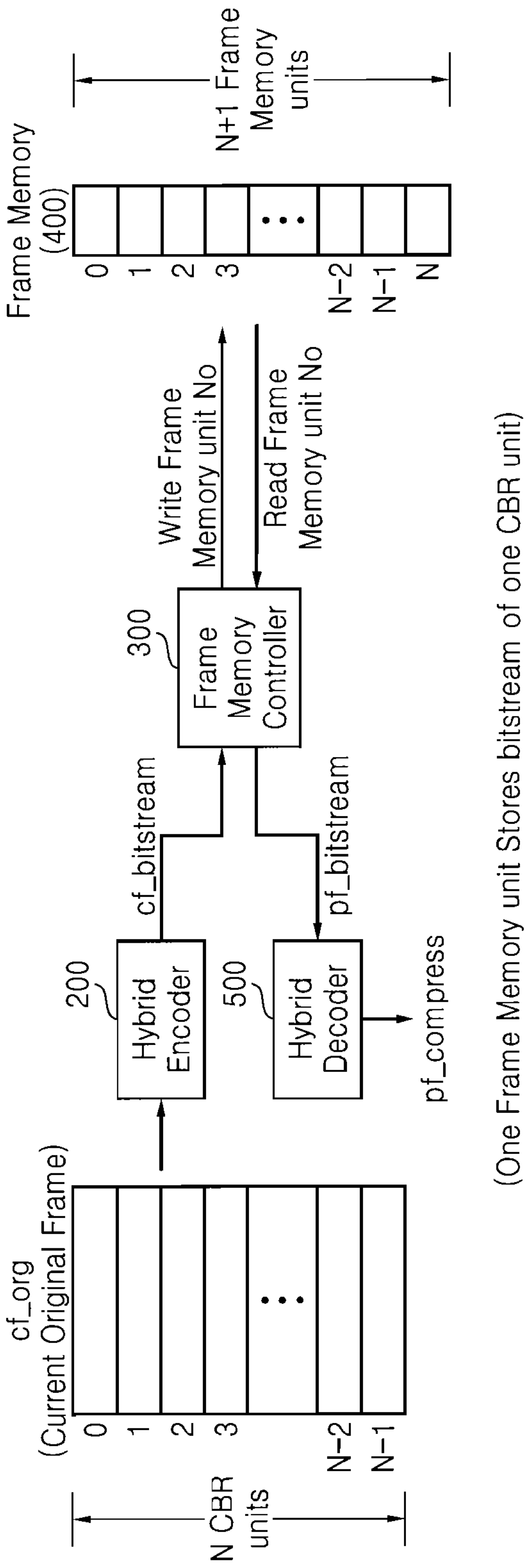

N CBR units
cf_org (Current Original Frame)
0
1
2
3
N-2
N-1
200
Hybrid Encoder
cf_bitstream
500
Hybrid Decoder
pf_compress
pf_bitstream
300
Frame Memory Controller
Write Frame Memory unit No
Read Frame Memory unit No
Frame Memory (400)
0
1
2
3
N-2
N-1
N
N+1 Frame Memory units
(One Frame Memory unit Stores bitstream of one CBR unit)

FIG. 13

| Frame No / Frame Memory unit No / CBR unit No | F0 | | F1 | | F2 | | ... | |
|---|---|---|---|---|---|---|---|---|
| | READ | WRITE | READ | WRITE | READ | WRITE | ... | ... |
| 0 | 0 | N | N | N-1 | N-1 | N-2 | ... | ... |
| 1 | 1 | 0 | 0 | N | N | N-1 | ... | ... |
| 2 | 2 | 1 | 1 | 0 | 0 | N | ... | ... |
| 3 | 3 | 2 | 2 | 1 | 1 | 0 | ... | ... |
| ... | ... | ... | .... | .... | ... | ... | ... | ... |
| N-2 | N-2 | N-3 | N-3 | N-4 | N-4 | N-5 | ... | ... |
| N-1 | N-1 | N-2 | N-2 | N-3 | N-3 | N-4 | ... | ... |

FIG. 14

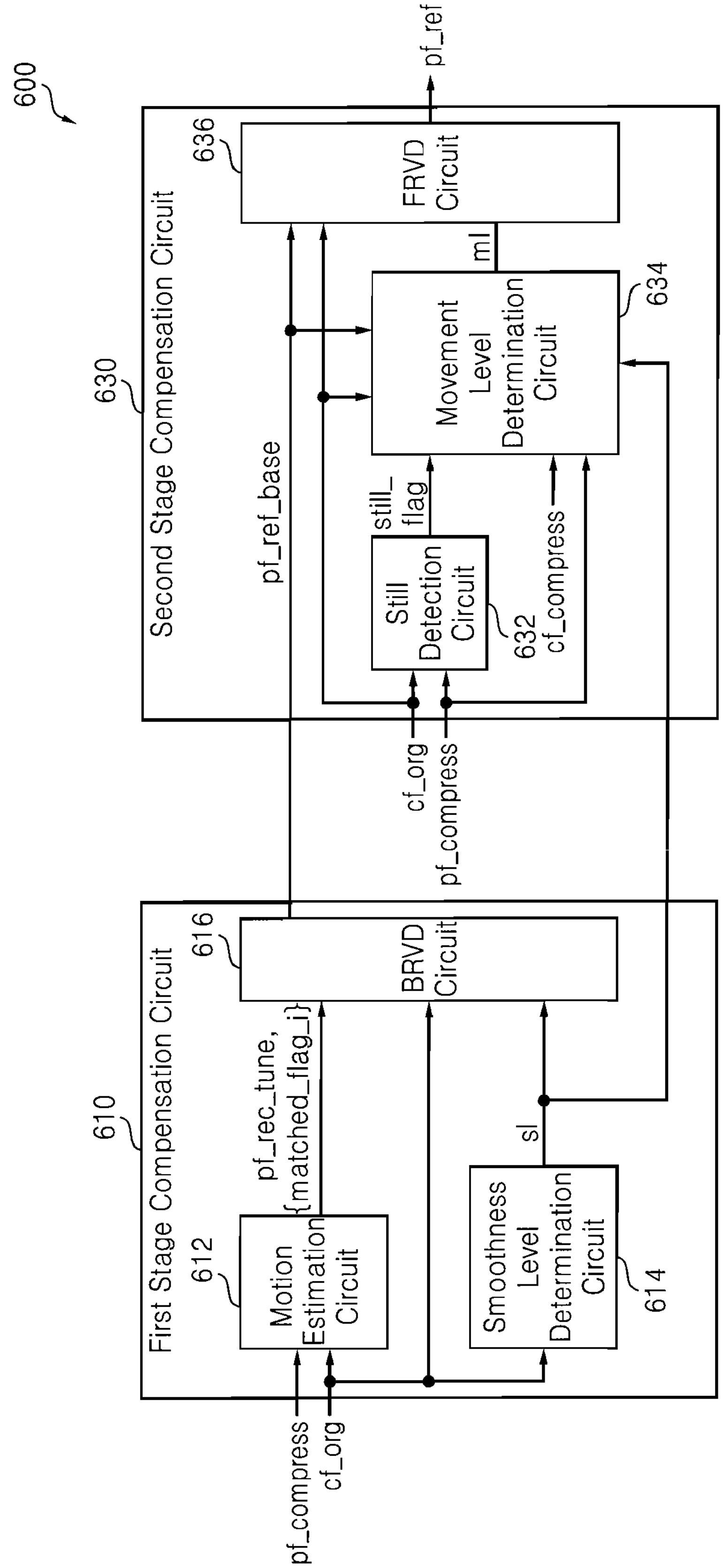
600
630
Second Stage Compensation Circuit
636
FRVD Circuit
pf_ref
ml
634
Movement Level Determination Circuit
pf_ref_base
still_flag
Still Detection Circuit
632
cf_compress
cf_org
pf_compress
610
First Stage Compensation Circuit
616
BRVD Circuit
pf_rec_tune, {matched_flag_i}
612
Motion Estimation Circuit
sl
Smoothness Level Determination Circuit
614
pf_compress
cf_org

FIG. 15

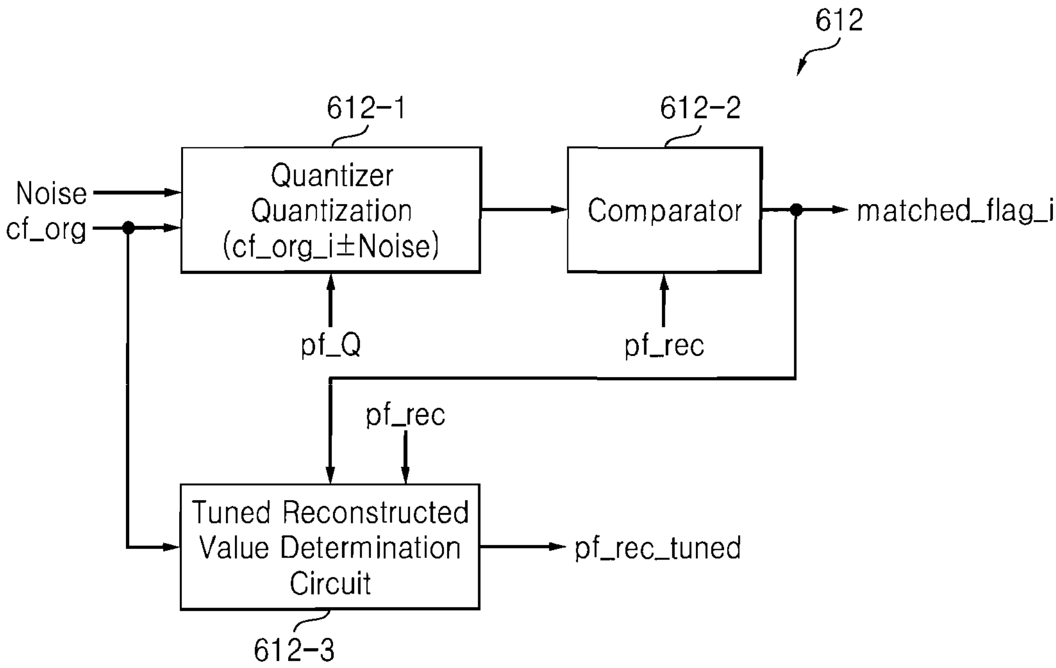
612
612-1
612-2
Noise
cf_org
Quantizer
Quantization
(cf_org_i±Noise)
Comparator
matched_flag_i
pf_Q
pf_rec
pf_rec
Tuned Reconstructed
Value Determination
Circuit
pf_rec_tuned
612-3

FIG. 16

pf_rec: reconstructed value of a pixel in previous frame
pf_Q: quantization level of a pixel in previous frame
cf_org_0: original value of the corresponding pixel in current frame
cf_org_1, ...: original value of neighboring pixels within a predefined search range in current frame

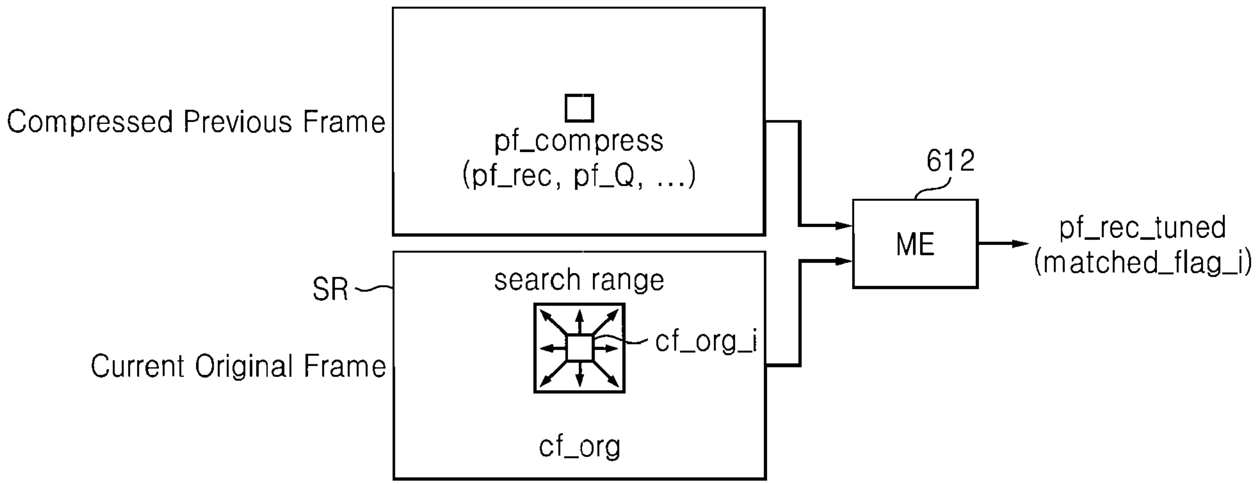

FIG. 17A

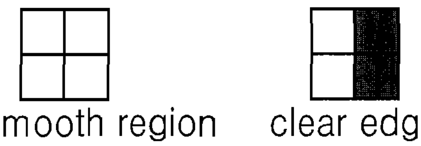

FIG. 17B

(m,n,i,j):

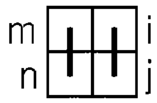

FIG. 17C

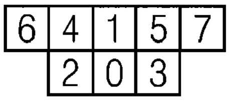


0: current pixel
1~7: neighboring pixels

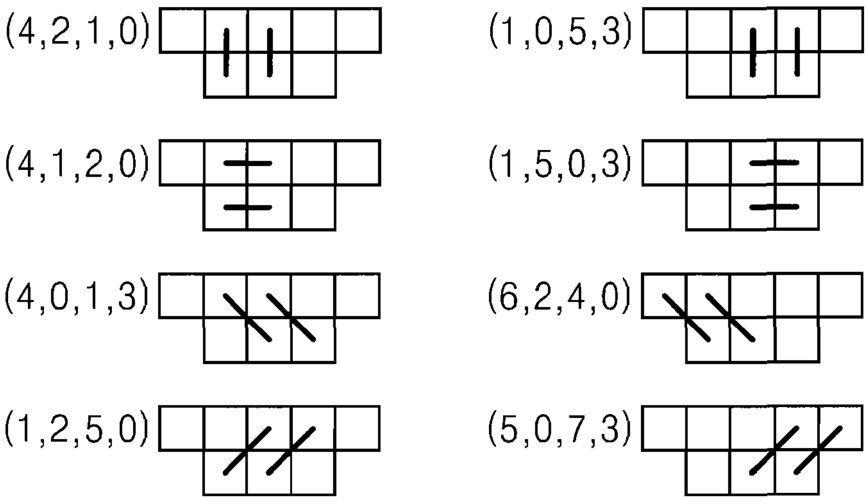

FIG. 18

801

| cf_org_cp_val \ pf_ref | 0 | 64 | 128 | 192 | 255 |
|---|---|---|---|---|---|
| 0 | OD1 | OD2 | | | |
| 64 | OD3 | OD4 | | 40 | |
| 128 | | | 128 | | |
| 192 | | 220 | | | |
| 255 | | | | | |

FIG. 19

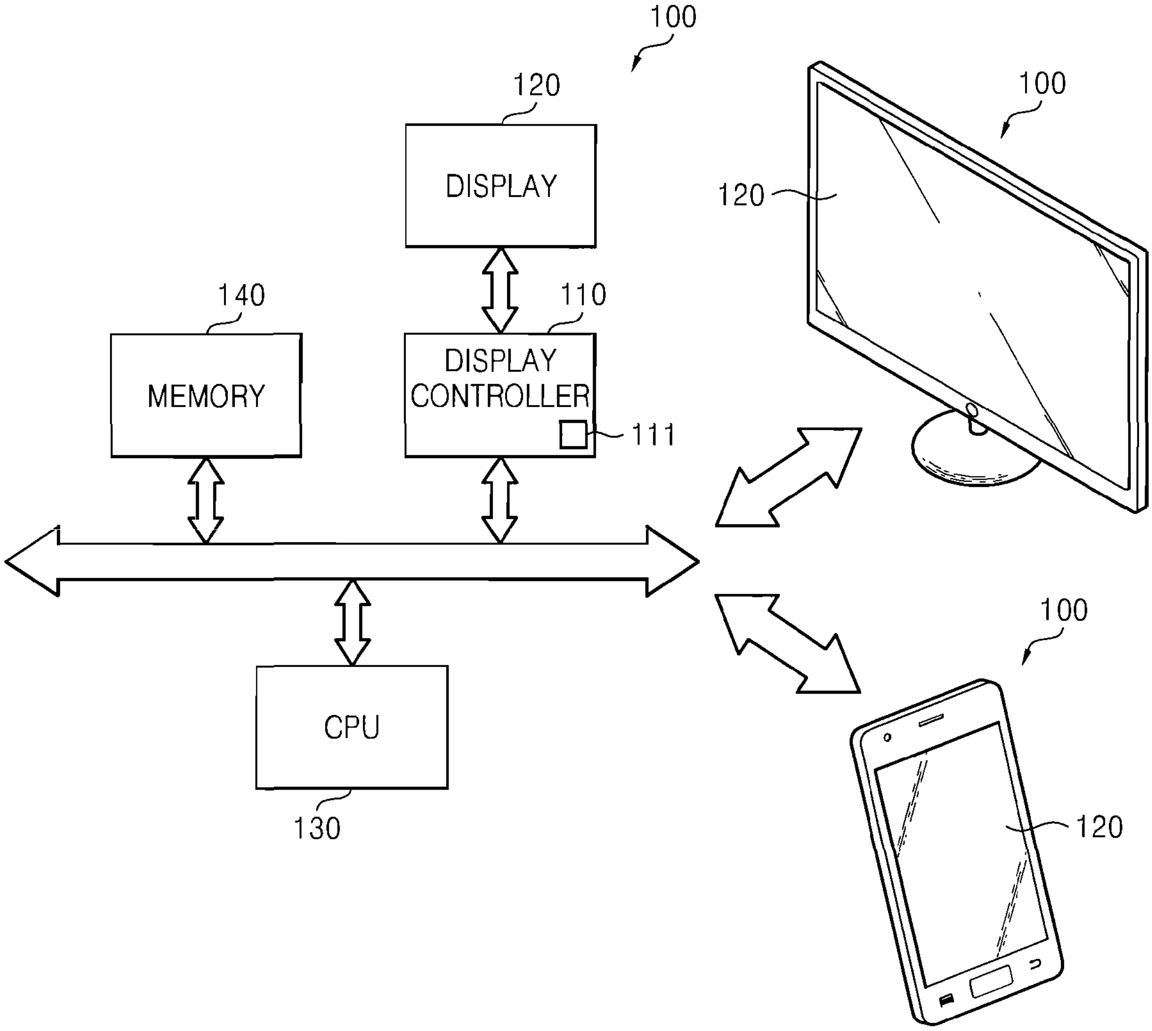
100
120
DISPLAY
140
110
MEMORY
DISPLAY
CONTROLLER
111
CPU
130
100
120
100
120

FIG. 20

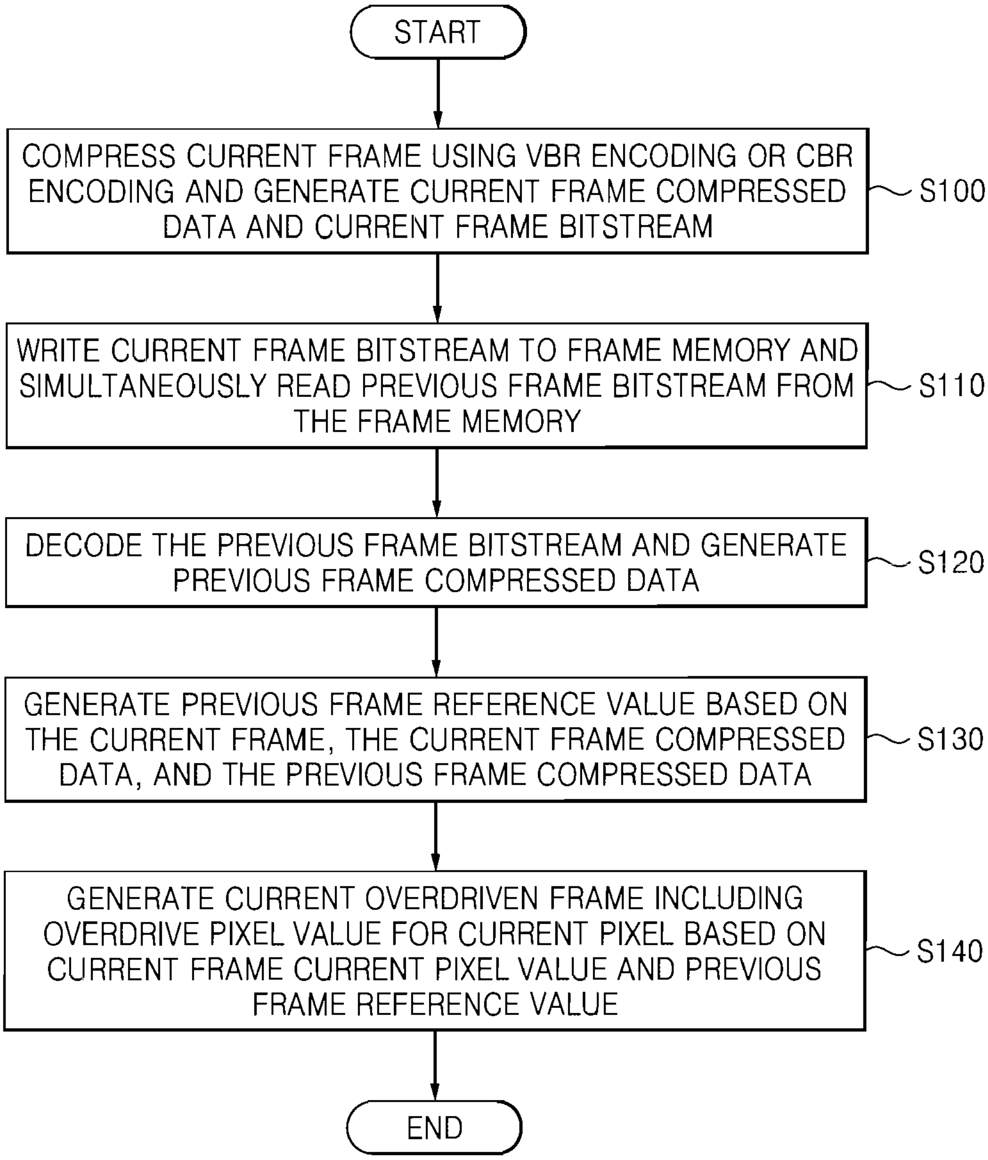
START
COMPRESS CURRENT FRAME USING VBR ENCODING OR CBR ENCODING AND GENERATE CURRENT FRAME COMPRESSED DATA AND CURRENT FRAME BITSTREAM
S100
WRITE CURRENT FRAME BITSTREAM TO FRAME MEMORY AND SIMULTANEOUSLY READ PREVIOUS FRAME BITSTREAM FROM THE FRAME MEMORY
S110
DECODE THE PREVIOUS FRAME BITSTREAM AND GENERATE PREVIOUS FRAME COMPRESSED DATA
S120
GENERATE PREVIOUS FRAME REFERENCE VALUE BASED ON THE CURRENT FRAME, THE CURRENT FRAME COMPRESSED DATA, AND THE PREVIOUS FRAME COMPRESSED DATA
S130
GENERATE CURRENT OVERDRIVEN FRAME INCLUDING OVERDRIVE PIXEL VALUE FOR CURRENT PIXEL BASED ON CURRENT FRAME CURRENT PIXEL VALUE AND PREVIOUS FRAME REFERENCE VALUE
S140
END

Europäisches Patentamt
European Patent Office
Office européen des brevets

# EUROPEAN SEARCH REPORT

Application Number
EP 13 18 4107

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/206290 A1 (KATAYAMA YUKARI [JP] ET AL) 25 August 2011 (2011-08-25)<br>* figure 1 *<br>* figure 2 *<br>* figure 7 *<br>* figure 9 *<br>* figure 10 *<br>* figure 12 *<br>* figure 13 *<br>----- | 1-6,9,10 | INV.<br>H04N19/426<br>G09G3/36<br>H04N19/146<br>H04N19/186<br>H04N19/14<br>H04N19/137<br>H04N19/85<br>H04N19/436<br>H04N19/124 |
| A | US 2009/085896 A1 (NAGASE AKIHIRO [JP] ET AL) 2 April 2009 (2009-04-02)<br>* figure 1 *<br>* figure 3 *<br>* figure 6 *<br>* figure 9 *<br>----- | 1,2,9,10 | |
| A | WO 99/37097 A1 (SARNOFF CORP [US]) 22 July 1999 (1999-07-22)<br>* figure 2 *<br>----- | 3 | |
| | | | TECHNICAL FIELDS SEARCHED (IPC) |
| A | EP 2 328 351 A2 (APPLE INC [US]) 1 June 2011 (2011-06-01)<br>* figure 1 *<br>* figures 2A, 2B, 2C *<br>----- | 5 | H04N<br>G09G |
| A | EP 1 524 860 A2 (NVIDIA CORP [US]) 20 April 2005 (2005-04-20)<br>* figure 2 *<br>* figures 3,4 *<br>* figure 5 *<br>----- | 1-6,9,10 | |
| A | US 2007/280294 A1 (HUNT DAN [US] ET AL) 6 December 2007 (2007-12-06)<br>* figure 2 *<br>----- | 1-6,9,10 | |
| A | EP 1 091 588 A1 (SONY CORP [JP]) 11 April 2001 (2001-04-11)<br>* figure 6 *<br>----- | 1-6,9,10 | |

3

~~The present search report has been drawn up for all claims~~

| Place of search | Date of completion of the search | Examiner |
|---|---|---|
| The Hague | 12 March 2014 | Martinière, Anthony |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

Application Number
EP 13 18 4107

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-6, 9, 10

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches Patentamt
European Patent Office
Office européen des brevets

## LACK OF UNITY OF INVENTION SHEET B

Application Number
EP 13 18 4107

The Search Division considers that the present European patent application does not comply with the requirements of unity of invention and relates to several inventions or groups of inventions, namely:

1. claims: 1, 2, 9, 10

Image compression circuit including an encoder, a frame memory (and its controller), a decoder, a dynamic capacitance compensation controller and an overdrive circuit. The encoder compresses a current frame. The frame memory controller saves it into a memory. The decoder decodes the previous frame from the memory. The dynamic capacitance compensation controller calculates a previous frame reference value based on the current frame, the current reconstructed frame and the previous frame. This previous frame reference value is then used by the overdrive circuit to generate an overdrive pixel value for a current pixel. Bit rate control is being used at the encoder in order to maintain the desired compression ratio.

---

2. claims: 3-6

Image compression circuit including an encoder, a frame memory (and its controller), a decoder, a dynamic capacitance compensation controller and an overdrive circuit. The encoder includes a plurality of variable and constant bit rate encoders in order to parallelize the encoding of the color components for improving coding efficiency in terms of speed.

---

3. claim: 7

Image compression circuit including an encoder, a frame memory (and its controller), a decoder, a dynamic capacitance compensation controller and an overdrive circuit. The frame memory comprises a plurality of frame memory units. This feature allows the controller to write the current frame to a frame memory unit and simultaneously read the current previous frame from another frame memory units, and thus avoids overwriting in the frame memory.

---

4. claim: 8

Image compression circuit including an encoder, a frame memory (and its controller), a decoder, a dynamic capacitance compensation controller and an overdrive circuit. The dynamic capacitance compensation controller calculates a smoothness level and uses it for generating the previous frame reference value. This feature allows a perceptual quality improvement of the overdriven pixels, the human eyes being more sensitive to distortions in smooth regions than in detailed regions.

Europäisches Patentamt
European Patent Office
Office européen des brevets

# LACK OF UNITY OF INVENTION SHEET B

Application Number

EP 13 18 4107

The Search Division considers that the present European patent application does not comply with the requirements of unity of invention and relates to several inventions or groups of inventions, namely:

---

## ANNEX TO THE EUROPEAN SEARCH REPORT ON EUROPEAN PATENT APPLICATION NO. EP 13 18 4107

This annex lists the patent family members relating to the patent documents cited in the above-mentioned European search report.
The members are as contained in the European Patent Office EDP file on
The European Patent Office is in no way liable for these particulars which are merely given for the purpose of information.

12-03-2014

| Patent document cited in search report | Publication date | Patent family member(s) | Publication date |
|---|---|---|---|
| US 2011206290 A1 | 25-08-2011 | CN 102163416 A | 24-08-2011 |
| | | JP 5358482 B2 | 04-12-2013 |
| | | JP 2011175085 A | 08-09-2011 |
| | | US 2011206290 A1 | 25-08-2011 |
| US 2009085896 A1 | 02-04-2009 | JP 4169768 B2 | 22-10-2008 |
| | | JP 2007259405 A | 04-10-2007 |
| | | KR 20080026112 A | 24-03-2008 |
| | | US 2009085896 A1 | 02-04-2009 |
| | | WO 2007097067 A1 | 30-08-2007 |
| WO 9937097 A1 | 22-07-1999 | AU 2216199 A | 02-08-1999 |
| | | EP 1050168 A1 | 08-11-2000 |
| | | JP 2003524904 A | 19-08-2003 |
| | | US RE42589 E1 | 02-08-2011 |
| | | US 6829301 B1 | 07-12-2004 |
| | | WO 9937097 A1 | 22-07-1999 |
| EP 2328351 A2 | 01-06-2011 | EP 1721467 A2 | 15-11-2006 |
| | | EP 2328351 A2 | 01-06-2011 |
| | | WO 2005084035 A2 | 09-09-2005 |
| EP 1524860 A2 | 20-04-2005 | EP 1524860 A2 | 20-04-2005 |
| | | EP 1912442 A2 | 16-04-2008 |
| | | JP 4388877 B2 | 24-12-2009 |
| | | JP 2005192193 A | 14-07-2005 |
| | | SG 111296 A1 | 30-05-2005 |
| | | TW I245570 B | 11-12-2005 |
| | | US 2005084007 A1 | 21-04-2005 |
| US 2007280294 A1 | 06-12-2007 | NONE | |
| EP 1091588 A1 | 11-04-2001 | EP 1091588 A1 | 11-04-2001 |
| | | JP 4706104 B2 | 22-06-2011 |
| | | US 6661840 B1 | 09-12-2003 |
| | | WO 0065842 A1 | 02-11-2000 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020120101506